(19) Europäisches Patentamt / European Patent Office / Office européen des brevets

(11) **EP 3 119 163 A1**

(12) **EUROPEAN PATENT APPLICATION**
published in accordance with Art. 153(4) EPC

(43) Date of publication:
**18.01.2017 Bulletin 2017/03**

(51) Int Cl.:
*H05B 33/02* (2006.01)    *G02B 5/02* (2006.01)
*H01L 51/50* (2006.01)    *H05B 33/10* (2006.01)
*H05B 33/14* (2006.01)    *H05B 33/22* (2006.01)

(21) Application number: 15761730.9

(22) Date of filing: **04.03.2015**

(86) International application number:
**PCT/JP2015/056302**

(87) International publication number:
**WO 2015/137205 (17.09.2015 Gazette 2015/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **10.03.2014  JP 2014045970**

(71) Applicant: **Konica Minolta, Inc.**
**Tokyo 100-7015 (JP)**

(72) Inventor: **OSAWA, Kou**
**Tokyo 100-7015 (JP)**

(74) Representative: **Hoffmann Eitle**
**Patent- und Rechtsanwälte PartmbB**
**Arabellastraße 30**
**81925 München (DE)**

(54) **ELECTROLUMINESCENCE ELEMENT, ILLUMINATION DEVICE, AND METHOD FOR MANUFACTURING ELECTROLUMINESCENCE ELEMENT**

(57)     An electroluminescent device (1) includes a light scattering layer (11). The light scattering layer (11) contains a binder (11a) provided on a side of a transparent substrate (10) and a plurality of light scattering particles (11b) bonded by the binder (11a) and provided on a side of a smooth layer (12). The plurality of light scattering particles (11b) are bonded by the binder (11a) such that a projected two-dimensional area (S1) when the light scattering particles (11b) are viewed in a direction (PL) of a surface normal to a main surface of a light emitting layer (14) is greater than a whole-circumference average area (S2) when the light scattering particles (11b) are viewed in a direction orthogonal to the direction (PL) of the surface normal to the main surface of the light emitting layer (14).

FIG.2

12:SMOOTH LAYER
11b:LIGHT SCATTERING PARTICLE
11a:BINDER
11:LIGHT SCATTERING LAYER
10:TRANSPARENT SUBSTRATE

**Description**

TECHNICAL FIELD

This invention relates to an electroluminescent device, a lighting apparatus, and a method of manufacturing an electroluminescent device.

BACKGROUND ART

A surface light source high in luminous efficiency which includes an electroluminescent device such as a light-emitting diode (LED), an organic electroluminescence (EL), or an inorganic EL has recently attracted attention. The electroluminescent device is formed from an emissive layer lying between a planar cathode and a planar anode. Generally in many cases, a transparent electrode layer serves as an anode and a light reflective electrode layer made of a metal serves as a cathode. When one electrode is formed from a light reflective electrode layer made of a metal, light is taken out of an anode side of the transparent electrode layer and a single-side emission light emitting device is obtained. Here, such loss of light in a waveguide mode that light is confined due to total reflection caused by a difference in refractive index between a substrate low in refractive index and an organic layer high in refractive index gives rise to a problem.
As a method of extracting light to the outside by scattering such light in the waveguide mode, a method of providing a scattering layer between a substrate and a transparent electrode layer is disclosed in Japanese Laid-Open Patent Publications Nos. 2009-76452 (PTD 1) and 2012-69277 (PTD 2). A method of reducing light loss (a substrate mode) due to total reflection between a substrate and air is disclosed in Japanese Laid-Open Patent Publication No. 2010-212184 (PTD 3).

CITATION LIST

PATENT DOCUMENT

PTD 1: Japanese Laid-Open Patent Publication No. 2009-076452
PTD 2: Japanese Laid-Open Patent Publication No. 2012-069277
PTD 3: Japanese Laid-Open Patent Publication No. 2010-212184

SUMMARY OF INVENTION

TECHNICAL PROBLEM

In the construction disclosed in PTD 1, however, it is expected that, by providing a scattering layer between a substrate and a transparent electrode layer, light which has not conventionally been confined because of total reflection is scattered, consequently light cannot be extracted to the contrary, and light cannot sufficiently be extracted. In the construction disclosed in PTD 2, a process for perpendicularly disposing particles is complicated, which leads to difficulty in mass production.
Furthermore, a problem common to PTDs 1 and 2 is that there has been a great height difference between a portion where particles are present and a portion where particles are absent and a smooth layer large in thickness should be stacked in order to lessen the height difference, which has led to increase in manufacturing cost.
PTD 3 has not clarified a desired construction in providing a scattering layer between a substrate and a transparent electrode layer.
This invention was made in view of the problems above, and provides an electroluminescent device, a lighting apparatus, and a method of manufacturing a electroluminescent device which allow improvement in luminous efficiency of an electroluminescent device by efficiently scattering light in a waveguide mode in the electroluminescent device.

SOLUTION TO PROBLEM

An electroluminescent device according to one aspect of this invention includes a light emitting layer which emits light, a first electrode layer provided on a surface on one side of the light emitting layer, through which light emitted from the light emitting layer can pass, a second electrode layer provided on a surface on the other side of the light emitting layer, a smooth layer provided opposite to a side where the light emitting layer is provided, with the first electrode layer being interposed, a light scattering layer provided opposite to a side where the first electrode layer is provided, with the smooth layer being interposed, and a transparent substrate provided opposite to a side where the smooth layer is provided, with the light scattering layer being interposed.

The light scattering layer contains a binder provided on a side of the transparent substrate and a plurality of light scattering particles bonded by the binder and provided on a side of the smooth layer, and the plurality of light scattering particles are bonded by the binder such that a projected two-dimensional area when the light scattering particles are viewed in a direction of a surface normal to a main surface of the light emitting layer is greater than a whole-circumference average area when the light scattering particles are viewed in a direction orthogonal to the direction of the surface normal to the main surface of the light emitting layer.

A lighting apparatus according to another aspect of this invention includes the electroluminescent device described above.

A method of manufacturing an electroluminescent device according to yet another aspect of this invention includes the steps of preparing a transparent substrate having a main surface, forming a light scattering layer on the main surface, forming a smooth layer on the light scattering layer, forming on the smooth layer, a first electrode layer through which light can pass, forming a light emitting layer on the first electrode layer, and forming a second electrode layer on the light emitting layer.

The step of forming a light scattering layer includes the steps of applying an ink obtained by dispersing a binder and a plurality of light scattering particles in a volatile solvent to the main surface of the transparent substrate and volatilizing the solvent by drying the ink and bonding each of the plurality of light scattering particles with the binder such that a projected two-dimensional area when the light scattering particles are viewed in a direction of a surface normal to a main surface of the light emitting layer is greater than a whole-circumference average area when the light scattering particles are viewed in a direction orthogonal to the direction of the surface normal to the main surface of the light emitting layer.

BRIEF DESCRIPTION OF DRAWINGS

Fig. 1 is a vertical cross-sectional view showing a structure of an electroluminescent device in a first embodiment.
Fig. 2 is a partially enlarged cross-sectional view showing a layered structure of a light scattering layer in the first embodiment.
Fig. 3 is a first diagram showing an effect of selective scattering of light in a waveguide mode by light scattering particles arranged substantially in parallel to a surface of a light emitting layer in the first embodiment.
Fig. 4 is a second diagram showing an effect of selective scattering of light in the waveguide mode by the light scattering particles arranged substantially in parallel to the surface of the light emitting layer in the first embodiment.
Fig. 5 is a first diagram showing arrangement of the light scattering particles in the first embodiment.
Fig. 6 is a second diagram showing arrangement of the light scattering particles in the first embodiment.
Fig. 7 is a third diagram showing arrangement of the light scattering particles in the first embodiment.
Fig. 8 is a plan view illustrating a ratio occupied by the light scattering particles in a second embodiment.
Fig. 9 is a cross-sectional view along the line IX-IX in Fig. 8.
Fig. 10 is a plan view of the light scattering particle in the second embodiment.
Fig. 11 is a diagram showing other forms (A) to (H) of the light scattering particle in the second embodiment.
Fig. 12 is a cross-sectional view for illustrating a condition for a desirable refractive index of light scattering particles, a binder, and a smooth layer in a third embodiment.
Fig. 13 is a vertical cross-sectional view showing a structure of the electroluminescent device in a fourth embodiment.
Fig. 14 is a partially enlarged cross-sectional view showing a structure of the light scattering layer in the fourth embodiment.
Fig. 15 is a partially enlarged cross-sectional view showing another structure of the light scattering layer in the fourth embodiment.
Fig. 16 is a flowchart showing a process for manufacturing an electroluminescent device in a fifth embodiment.
Fig. 17 is a diagram showing one example of a lighting apparatus in a sixth embodiment.

DESCRIPTION OF EMBODIMENTS

An electroluminescent device, a lighting apparatus including the electroluminescent device, and a method of manufacturing an electroluminescent device in an embodiment based on the present embodiment will be described hereinafter with reference to the drawings. When the number or an amount is mentioned in an embodiment described below, the scope of the present embodiment is not necessarily limited to the number or the amount unless otherwise specified. The same or corresponding elements have the same reference numeral allotted and redundant description may not be repeated. Combination of features in each embodiment as appropriate is originally intended.

(First Embodiment: Structure of Electroluminescent Device 1)

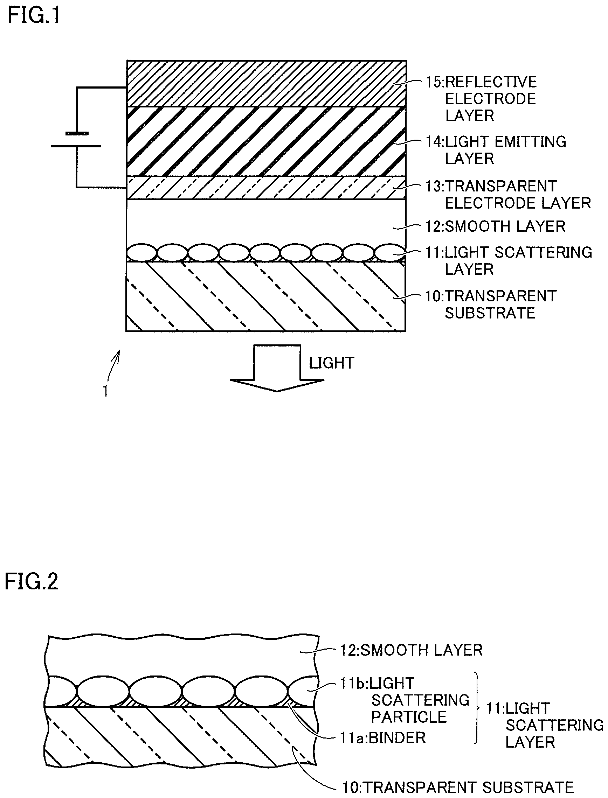

A structure of an electroluminescent device 1 in a first embodiment will be described with reference to Figs. 1 and 2. Fig. 1 is a vertical cross-sectional view showing a structure of electroluminescent device 1 in the first embodiment. Fig. 2 is a partially enlarged cross-sectional view showing a layered structure of a light scattering layer 11. In electroluminescent device 1 in the present embodiment, light scattering layer 11, a smooth layer 12, a transparent electrode layer 13 representing one example of a first electrode layer, a light emitting layer 14, and a reflective electrode layer 15 representing one example of a second electrode layer are stacked in this order on a transparent substrate 10.

(Light Scattering Layer 11)

Referring to Fig. 2, light scattering layer 11 is formed of a binder 11a and light scattering particles 11b. Light scattering layer 11 has a thickness, for example, around 150 nm. Though Fig. 2 schematically shows a state that light scattering particles 11b are arranged as being aligned, an actually disposed state will be described later.
Here, a form of light scattering particles 11b is not perfectly spherical but has a major axis. The major axis of light scattering particle 11b means a longest axis which can be observed when light scattering particle 11b is arbitrarily rotated while it is projected. A minor axis of light scattering particle 11b means a shortest axis which can be observed when light scattering particle 11b is arbitrarily rotated while it is projected.

(Light Emitting Layer 14)

Referring again to Fig. 1, light emitting layer 14 is located as lying between transparent electrode layer 13 and reflective electrode layer 15. Light emitting layer 14 has a thickness around 100 nm. An anode can be formed by transparent electrode layer 13 and a cathode can be formed by reflective electrode layer 15, and vice versa. A construction in which an anode is formed by transparent electrode layer 13 and a cathode is formed by reflective electrode layer 15 will be described below.

(Transparent Electrode Layer 13 and Reflective Electrode Layer 15)

As a voltage is applied across transparent electrode layer 13 and reflective electrode layer 15, electrons are accelerated and injected into light emitting layer 14 so that kinetic energy of electrons is converted to photons in light emitting layer 14. Thus, light is extracted from light emitting layer 14 toward transparent substrate 10. Transparent electrode layer 13 has a thickness around 10 nm and reflective electrode layer 15 has a thickness around 100 nm.
In general, for facilitating injection of electrons, different materials are used for transparent electrode layer 13 and reflective electrode layer 15. For example, a metal electrode (Ag, Al, Au, or Cu) having a work function suitable for injection of electrons is employed for a cathode side, and a transparent oxide semiconductor electrode (indium tin oxide (ITO) or indium zinc oxide (IZO)) having a work function suitable for injection of holes is employed for an anode side.
Though a metal electrode is excellent in electron transferability, it is low in optical transmittance. Therefore, when the metal electrode is employed for transparent electrode layer 13, a metal electrode having a thickness from several nm to several ten nm is suitable for raising a transmittance. Transparent electrode layer 13 composed of a transparent oxide semiconductor is higher in surface resistance per thickness and higher in light transmittance than a small-thickness metal electrode. Therefore, when a transparent oxide semiconductor is employed for transparent electrode layer 13, a transparent oxide semiconductor having a thickness from 100 nm to 200 nm is suitable for lowering in surface resistance.
When transparent electrode layer 13 of the same type is used for transparent electrode layer 13 and reflective electrode layer 15, undesirably, electron injection performance is lowered, a drive voltage is higher, and luminous efficiency lowers. Therefore, different materials are used for transparent electrode layer 13 and reflective electrode layer 15, so that desirably one has high electron injection capability and the other has high hole injection capability.

(Light Scattering Layer 11)

As shown in Fig. 2, light scattering layer 11 is more specifically composed of binder 11a and light scattering particles 11b. Though details will be described later, each of a plurality of light scattering particles 11b is bonded by binder 11a such that a projected two-dimensional area S1 when light scattering particles 11b are viewed in a direction PL of a surface normal to a main surface of light emitting layer 14 is greater than a whole-circumference average area S2 when light scattering particles 11b are viewed in a direction orthogonal to direction PL of the surface normal to the main surface of light emitting layer 14. Smooth layer 12 is a layer for smoothing irregularities in light scattering layer 11 and has a thickness around 500 nm.

By thus arranging light scattering particles 11b, a ratio of light scattering particles 11b of which major axes are at an angle not smaller than 45 degrees with respect to the surface normal to the surface of light emitting layer 14 can be higher than a ratio of light scattering particles 11b of which major axes are at an angle smaller than 45 degrees. When smooth layer 12 is provided, energy in the waveguide mode is distributed across light emitting layer 14, transparent electrode layer 13, smooth layer 12, and light scattering layer 11.

Though detailed principles will be described later, light scattering particles 11b close to being in parallel to the surface of light emitting layer 14 have an effect to selectively scatter only light in the waveguide mode confined between light emitting layer 14 and smooth layer 12. Therefore, efficiency in extracting light in the waveguide mode on the side of transparent substrate 10 is enhanced by adopting the construction of light scattering layer 11 in the present embodiment.

Binder 11a of light scattering layer 11 may cover light scattering particles 11b. Desirably, however, a thickness of binder 11a is set to such an extent that light scattering particles 11b protrude from binder 11a into smooth layer 12. By decreasing a thickness of binder 11a, scattering by light scattering particles 11b can be greater.

In Fig. 2, a construction including a transparent electrode layer instead of reflective electrode layer 15 is also applicable. In this case, light can be extracted on both of the side of transparent substrate 10 and a side of reflective electrode layer 15. Such an electroluminescent device can be made use of as a transparent dual emission electroluminescent device. When a transparent electrode layer is employed instead of reflective electrode layer 15, a waveguide mode component scattered by the light scattering particles can more efficiently be extracted to the outside because a light component absorbed in the reflective electrode layer and plasmon mode loss caused in the reflective electrode layer can be reduced.

(Scattering Effect)

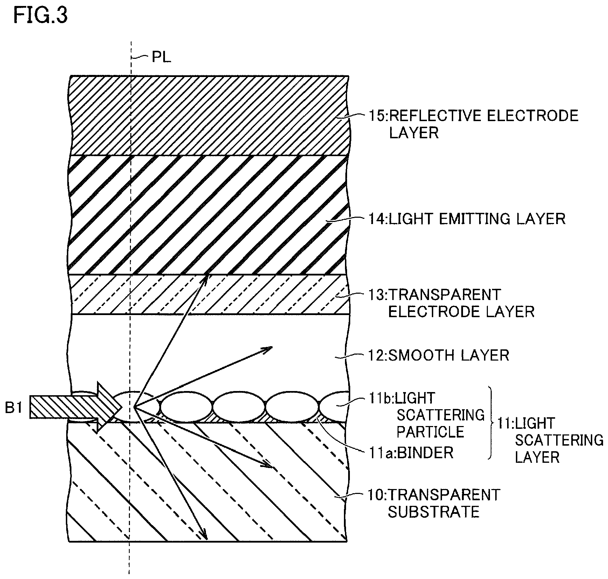

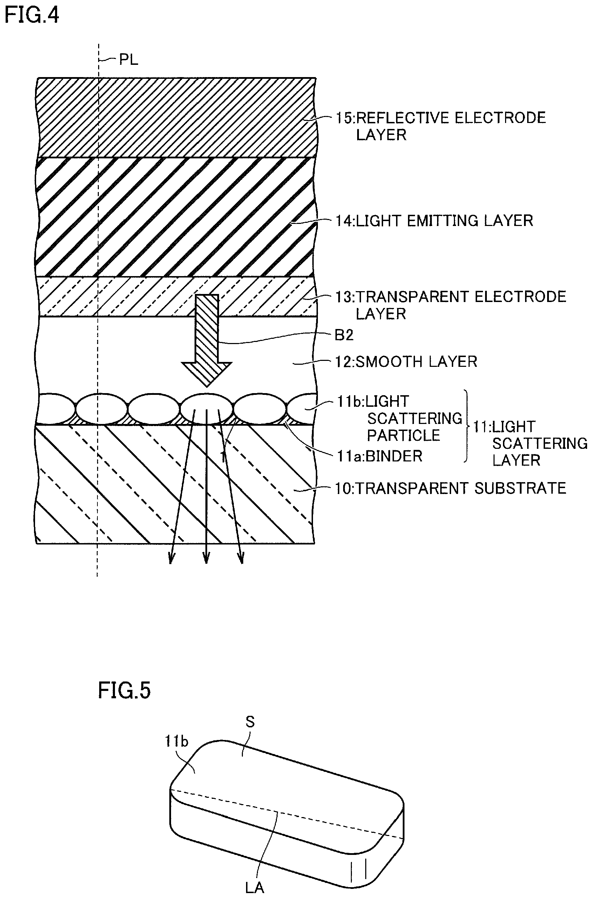

An effect of selective scattering by light scattering particles 11b arranged substantially in parallel to the surface of light emitting layer 14, of light B1 in the waveguide mode confined between smooth layer 12 and light emitting layer 14 will be described with reference to Figs. 3 and 4.

Referring to Fig. 3, when viewed from light emitting layer 14, light B1 in the waveguide mode is approximated as light which propagates in a direction at an angle of 90 degrees with respect to direction PL of the surface normal to light emitting layer 14, with light emitting layer 14 and transparent electrode layer 13 being defined as a core.

Referring to Fig. 4, light B2 which can be extracted on the side of transparent substrate 10 without conventional confinement of light in the waveguide mode is approximated as light which propagates from light emitting layer 14 in a direction along direction PL of the surface normal to light emitting layer 14.

When the construction in the present embodiment is adopted, the major axes of light scattering particles 11b are arranged in directions close to parallel to the surface of light emitting layer 14. Therefore, light scattering particles 11b are approximated to a lens different in curvature between direction PL of the surface normal and a direction at an angle of 90 degrees with respect to the surface normal in terms of geometrical optics.

Referring again to Fig. 3, since a curvature of light scattering particles 11b is great for light B1 in the waveguide mode which propagates at an angle of 90 degrees with respect to direction PL of the surface normal in which confinement of light in the waveguide mode occurs, scattering at a large spreading angle occurs. Therefore, scattering selectively strong at an angle of 90 degrees with respect to direction PL of the surface normal in which confinement of light in the waveguide mode occurs can be realized.

Referring again to Fig. 4, since a curvature of light scattering particles 11b is small for light B2 which propagates in direction PL of the surface normal in which confinement of light in the waveguide mode does not occur, scattering at a small spreading angle occurs.

Similar principles are described also with reference to the Fresnel diffraction theory. For light which propagates in a direction of a surface normal in which confinement of light in the waveguide mode does not occur, an aperture area is large and hence light diffraction spreading is small. For light which propagates in a direction at an angle of 90 degrees with respect to the surface normal in which confinement of light in the waveguide mode occurs, an aperture area is small and hence diffraction spreading is large.

Thus, with less scattering of light emitted to the outside and selective scattering of light in the waveguide mode, light in the waveguide mode confined between light emitting layer 14 and smooth layer 12 can be extracted in a direction of transparent substrate 10.

(Arrangement of Light Scattering Particles 11b)

Arrangement of light scattering particles 11b will be described with reference to Figs. 5 to 7. Light scattering particle 11b shown in Fig. 5 is in a shape of a flat quadrangular prism of which corner portion is rounded. A major axis of light scattering particle 11b is defined as a major axis LA which is a longest line connecting opposite angles of long sides to each other.

In the present embodiment, each of the plurality of light scattering particles 11b is bonded by binder 11a such that projected two-dimensional area S1 when light scattering particles 11b are viewed in direction PL of the surface normal to the main surface of light emitting layer 14 is greater than whole-circumference average area S2 when light scattering particles 11b are viewed in a direction orthogonal to direction PL of the surface normal to the main surface of light emitting layer 14.

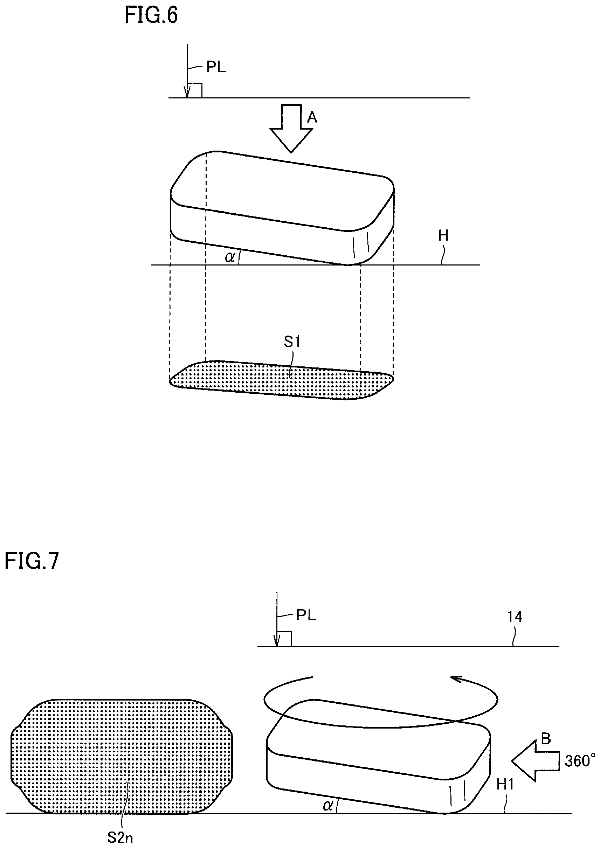

Projected two-dimensional area S1 will be described with reference to Fig. 6. Projected two-dimensional area S1 of light scattering particle 11b when viewed in a direction A along direction PL of the surface normal to the main surface of light emitting layer 14 is shown. Light scattering particle 11b is fixed as being inclined by an angle $\alpha°$ (for example, approximately 5°) with respect to a plane (corresponding to the main surface of light emitting layer 14) H. Projected two-dimensional area S1 in this case is greater than a two-dimensional area S (see Fig. 5) of light scattering particle 11b.

In actually measuring projected two-dimensional area S1, measurement does not necessarily have to be conducted for individual light diffusion particles 11b or for entire light scattering layer 11. In actual measurement, in a prescribed area of light scattering layer 11, an average value for an area occupied by light scattering particles 11b when viewed in direction A along direction PL of the surface normal to the main surface of light emitting layer 14 is determined and this average value may be defined as projected two-dimensional area S1. Naturally, accuracy in measurement is improved as a measured area is larger.

Whole-circumference average area S2 will be described with reference to Fig. 7. When light scattering particle 11b is viewed in a direction B orthogonal to direction PL of the surface normal to the main surface of light emitting layer 14, for example, a projected area S2n is measured every one degree (n being 1 to 360). Fig. 7 shows projected area S2n when viewed at a certain angle. A value calculated by dividing a total of 360 projected areas S2n by 360 after measurement is defined as whole-circumference average area S2.

In actually measuring whole-circumference average area S2, measurement does not necessarily have to be conducted for individual light scattering particles 11b or for a whole circumference (360 degrees). For example, electroluminescent device 1 may be cut along a plane in parallel to direction A along direction PL of the surface normal to a main plane of light emitting layer 14, an average value for an area of light scattering particles 11b which appear in the cut surface may be determined, and the average value may be defined as whole-circumference average area S2. When a degree of variation in arrangement (a distribution, a direction of inclination, or an angle $\alpha°$ of inclination) of light scattering particles 11b in light scattering layer 11 is assumed to substantially be even substantially over the entire light scattering layer 11, measurement should only be conducted by cutting electroluminescent device 1 at at least one location. Even when a degree of variation in arrangement of light scattering particles 11b is uneven, measurement at higher accuracy can be conducted by cutting the electroluminescent device at a plurality of locations (for example, approximately from 2 to 4 locations) and determining an average value for an area of light scattering particles 11b. As the number of locations of cutting and measurement is greater, naturally, accuracy in measurement is improved.

(Second Embodiment: Ratio of Light Scattering Particles 11b)

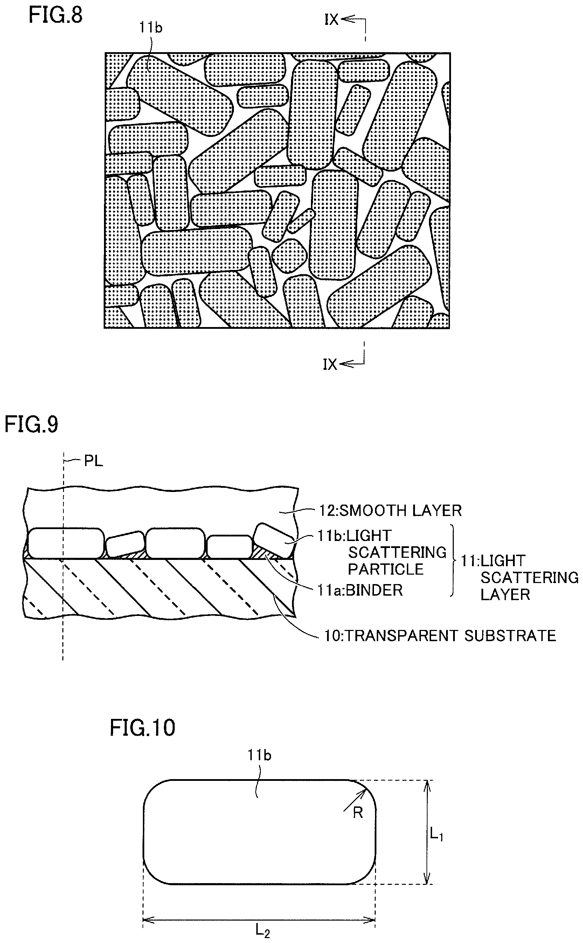

A desired ratio of light scattering particles 11b when viewed in direction A along direction PL of the surface normal to the main surface of light emitting layer 14 will be described with reference to Figs. 8 to 11 in a second embodiment. A portion hatched with dots in Fig. 8 represents a portion occupied by light scattering particles 11b.

Since some of light emitted in light emitting layer 14 is confined in light in the waveguide mode in all regions, light scattering particles 11b desirably cover the entire surface of light emitting layer 14. A closest packing density may not be 100% depending on a shape of light scattering particles 11b.

In this case, a ratio of light scattering particles 11b is desirably 90% or higher for efficient scattering. Light scattering particle 11b shown in Fig. 5 will be described here. When light scattering particle 11b is arranged at an angle of 90 degrees with respect to direction PL of the surface normal to light emitting layer 14, one light scattering particle 11b when viewed from above is in a two-dimensional shape as in Fig. 10. A ratio S of an area occupied by light scattering particle 11b in a parallelepiped which covers light scattering particle 11b when viewed in the direction of the surface normal to light emitting layer 14 can be expressed in an (expression 1) below, where L1 represents a length of a short side of light scattering particle 11b, L2 represents a length of a long side of light scattering particle 11b, and R represents a radius of a corner.

$$1 - \frac{(4 - \pi)R^2}{L_1 L_2}$$

... (Expression 1)

It can be seen that S = 0.99 and the light scattering particle occupies an area of 99% at the maximum, for example, when a condition of R = $L_1/8$ and $L_2 = 3 \times L_1$ is set. When a plurality of light scattering particles 11b are oriented in random directions while the major axes in a surface direction keep an angle of 90 degrees with respect to the surface normal to light emitting layer 14, an area occupied by the light scattering particles is lowered from this value, however, the light scattering particles can occupy an area of 90%.

Light scattering particles 11b different in size are desirably present as being mixed. Since an amount of beam spreading of light in the waveguide mode generally depends on a wavelength, light in the waveguide mode different in wavelength can efficiently be scattered by containing a plurality of light scattering particles 11b different in size from one another.

With a plurality of light scattering particles 11b being different in size, an area exclusively used by light scattering particles 11b in the surface can be increased and efficient scattering can be achieved. A plurality of ratios between the major axes and the minor axes of light scattering particles (particles asymmetric in shape) 11b will bring about an effect of uniform scattering characteristics and uniform light distribution characteristics.

Fig. 8 shows an example in which major axes of light scattering particles 11b satisfying requirements of the present embodiment are oriented in random directions in a surface. Light scattering particles 11b are not necessarily stacked in one layer but may be stacked in multiple layers. When light scattering particles are stacked in multiple layers, a ratio of light scattering particles 11b when viewed in direction PL of the surface normal to light emitting layer 14 can be made uniform and in-plane uniformity of emission intensity can be improved.

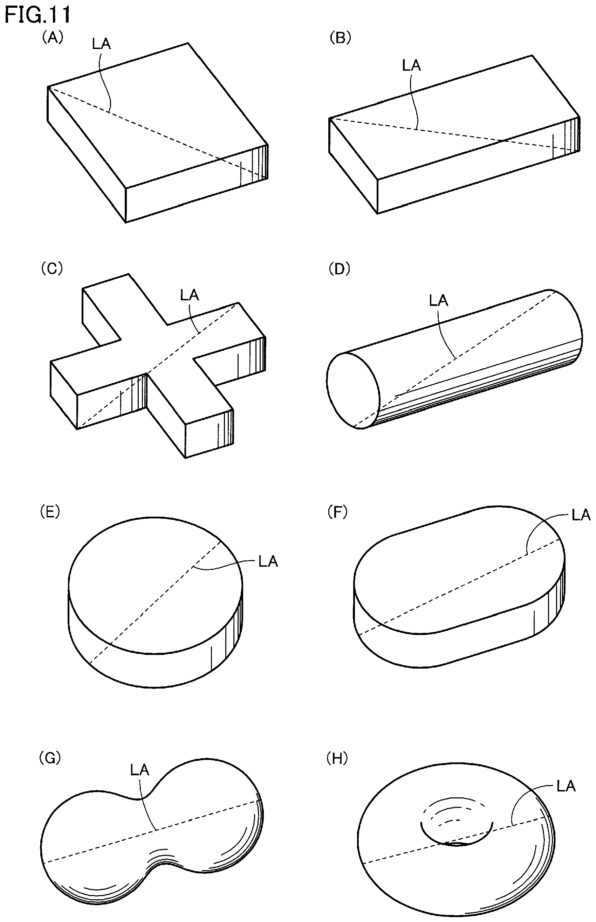

As shown in Fig. 11, various forms of light scattering particle 11b can be selected. In the present embodiment, a form of light scattering particle 11b should only be in a form other than a sphere (a perfect sphere), and it may be in a form of (A) a prism, (B) a parallelepiped, (C) a cross, (D) a rod, (E) a column, (F) an oval (a track field), (G) a peanut, or (H) a torus. LA in the figure indicates a position of a major axis in each form. A plurality of types of shapes may be combined. When a plurality of types of shapes are combined, wavelength dependency of scattering efficiency can advantageously be lessened.

(Third Embodiment: Condition for Refractive Index)

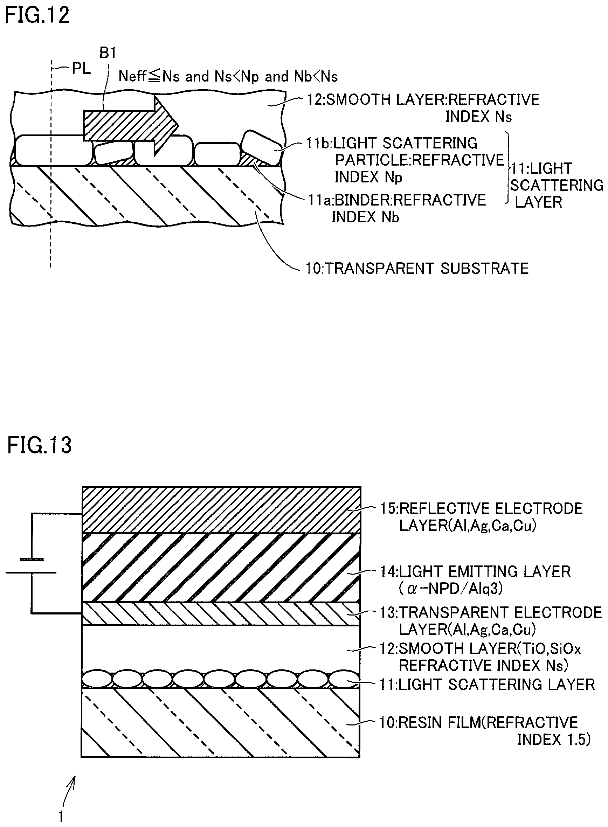

A desirable condition for an refractive index of light scattering particles 11b, binder 11a, and smooth layer 12 will be described with reference to Fig. 12 in a third embodiment. In the present embodiment, relation in an (expression 2) below is preferably satisfied, where Neff represents an effective refractive index of light in the waveguide mode which propagates through light emitting layer (organic layer) 14 at an emission wavelength in the absence of light scattering layer 11 and smooth layer 12, Ns represents an refractive index of smooth layer 12 at the emission wavelength, Np represents an refractive index of light scattering particles 11b, and Nb represents an refractive index of binder 11a.

$$\text{Neff} \leq \text{Ns and Ns} < \text{Np and Nb} < \text{Ns} \qquad \text{... (Expression 2)}$$

The effective refractive index of light in the waveguide mode can be calculated by using an existing method for analyzing light in the waveguide mode such as a transfer matrix method, a finite element method, a beam propagation method, and a finite-difference time-domain (FDTD) method. When transparent substrate 10 has an refractive index Nsub, relation in an (expression 6) below is preferably satisfied between refractive index Nsub and effective refractive index Neff of light in the waveguide mode. For the effective refractive index, for example, reference to "Hikari Shuseki Kairo Kiso to Ouyou," edited by The Japan Society of Applied Physics, Kougaku Konwa Kai, Asakura Publishing Co., Ltd. (1988) is to be made.

$$\text{Nsub} \leq \text{Neff (maximum refractive index of light emitting layer 14 and}$$

$$\text{transparent electrode layer 13)} \qquad \text{... (Expression 3)}$$

By setting an refractive index of smooth layer 12 to be equal to or higher than an effective refractive index of light in the waveguide mode, energy of electromagnetic field of light in the waveguide mode can more effectively be moved to smooth layer 12 and light in the waveguide mode can be scattered by light scattering particles 11b. By setting an refractive index of light scattering particles 11b to be higher than an refractive index of smooth layer 12, energy of light in the waveguide mode which propagates through smooth layer 12 can effectively be scattered.

Desirably, refractive index Nb of binder 11a is lower than refractive index Ns of smooth layer 12. This is because Fresnel reflection loss is effectively lessened by setting an refractive index to be lower toward a light extraction side in order to finally extract light into air having an refractive index of 1. More desirably, refractive index Nb of binder 11a preferably satisfies relation in an (expression 4) below.

$$1 < Nb < Ns \qquad \text{... (Expression 4)}$$

In order to decrease Fresnel reflection loss, desirably, refractive index Nb of binder 11a has a value between refractive index Nsub of transparent substrate 10 and refractive index Ns of smooth layer 12.

(Fourth Embodiment)

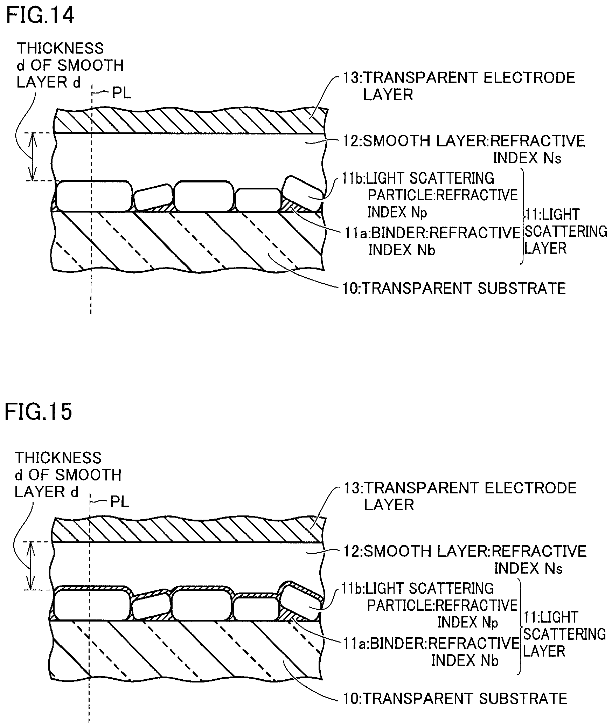

A specific material and an refractive index of transparent electrode layer 13, smooth layer 12, light scattering particles 11b, light emitting layer 14, and reflective electrode layer 15 included in electroluminescent device 1 will be described below with reference to Figs. 13 and 14 in a fourth embodiment. Electroluminescent device 1 shown in Fig. 13 is the same as electroluminescent device 1 shown in Fig. 1.

(Transparent Electrode Layer 13: Transparent Small-thickness Metal)

For transparent electrode layer 13, in particular a transparent small-thickness metal having an effect to lower an effective refractive index of light in the waveguide mode and to facilitate scattering of light in the waveguide mode in light scattering layer 11 is desirable. A transparent small-thickness metal layer is a small-thickness film which is composed of a small-thickness metal and allows passage of light therethrough. How thin the transparent small-thickness metal layer should be in order to allow passage of light therethrough can be expressed with an imaginary part of an refractive index. Phase variation $\phi$ and a transmittance T at the time of passage through a medium having a thickness d [m] can be expressed in an (expression 5) below with an refractive index n and an extinction coefficient $\kappa$.

$$\phi = n \frac{2\pi}{\lambda} d$$
$$T = \exp\left(-\kappa \frac{4\pi}{\lambda} d\right) \qquad \text{... (Expression 5)}$$

In the expression, $\lambda$ represents a wavelength of light in vacuum. Based on the expression (1), a distance Ld at which intensity of light is attenuated to $1/e^2$ can be expressed in an (expression 6) below. In order to have a sufficient transmittance, the transparent small-thickness metal layer is desirably smaller in thickness than $L_d$ shown in the expression (6).

$$L_d = \frac{\lambda}{2\pi\kappa} \qquad \text{... (Expression 6)}$$

Whether a substance is a metal which contains many free electrons and does not allow much passage of light therethrough or a dielectric which contains few free electrons and allows passage of light therethrough can be examined by using a complex relative permittivity. A complex relative permittivity $\varepsilon_c$ represents an optical constant associated with interface reflection, and it represents a physical quantity expressed with refractive index n and extinction coefficient $\kappa$ in an expression (7) below.

$$\varepsilon_c = \left(n^2 - \kappa^2\right) + 2in\kappa$$
$$\mathbf{P} = \left(\varepsilon_c - \varepsilon_o\right)\mathbf{E} \qquad \text{... (Expression 7)}$$

P and E represent polarization and electric field, respectively, and $\varepsilon_o$ represents a permittivity in vacuum. It can be seen from the expression (7) that as refractive index n is smaller and extinction coefficient $\kappa$ is greater, a real part of the complex relative permittivity is smaller. This represents an effect of phase shift from oscillation of electric field, of polarization response due to oscillation of electrons.

The negative real part of the complex relative permittivity expressed in the expression (7) means that electric field oscillation and polarization response are reversed, which represents characteristics of the metal. In contrast, when the real part of the complex relative permittivity is positive, a direction of electric field and a direction of polarization response match with each other and polarization response as a dielectric is exhibited. In summary, a medium of which real part of a complex relative permittivity is negative is a metal, and a substance of which real part of the complex relative permittivity is positive is a dielectric.

In general, a lower refractive index n and a greater extinction coefficient $\kappa$ mean a material of which electrons well oscillate. A material high in electron transferability tends to be low in refractive index n and great in extinction coefficient $\kappa$. In particular, a metal electrode has n around 0.1 whereas it has a large value for $\kappa$ from 2 to 10, and it is also high in rate of change with a wavelength. Therefore, even when a value for n is the same, a value for $\kappa$ is significantly different, and there is a great difference in performance in transfer of electrons in many cases.

In carrying out the present embodiment, a metal low in n for lowering in effective refractive index of light in the waveguide mode and high in $\kappa$ for improvement in response of electrons is desirable. For example, aluminum (Al), silver (Ag), and calcium (Ca) are desirable. In other examples, gold (Au) which is also advantageously less prone to oxidization is possible. Another material is exemplified by copper (Cu), and this material is high in conductivity.

Other materials which have good thermal properties or chemical properties, are less prone to oxidization even at a high temperature, and do not chemically react with a material for a substrate include platinum, rhodium, palladium, ruthenium, iridium, and osminium. An alloy containing a plurality of metal materials may be employed. In particular, MgAg or LiAl is often used for a small-thickness transparent metal electrode.

For transparent electrode layer 13, in addition to a transparent oxide semiconductor, a conductive resin which can be produced at low cost with an application method may be employed. A perylene derivative or a fullerene derivative such as [6,6]-phenyl-C61-butyric acid methyl ester (PCBM) is available as a conductive resin material used for an electron transfer electrode. For example, in a case of PCBM, an optical constant of visible light is (refractive index n = 2.2 and extinction coefficient $\kappa$ = 0.25) and a reflectance of an electrode viewed from light-emitting layer 14 is higher than that of a resin having an refractive index of 1.5.

Examples of a conductive resin material used for a hole transfer electrode include poly(3,4-ethylenedioxythiophene) (PEDOT)/poly(4-styrenesulfonate) (PSS), poly(3-hexylthiophene) (P3HT), poly(3-octylthiophene) (P3OT), poly(3-dodecylthiophene-2,5-diyl) (P3DDT), and a copolymer of fluorene and bithiophene (F8T2). For example, in a case of PEDOT/PSS, an optical constant of visible light is (refractive index n = 1.5 and extinction coefficient k = 0.01), and a reflectance of an electrode viewed from light-emitting layer 14 has a value comparable to that of a resin having an refractive index of n = 1.5 and the reflectance is relatively lower than that of PCBM.

In order to enhance electrical conductivity of transparent electrode layer 13, a metal mesh, a metal nanowire, or metal nanoparticles may be used together. In this case, with higher electron conductivity of an electrode including a metal nanowire, an average refractive index tends to be lower and a reflectance viewed from light-emitting layer 14 tends to be high. In carrying out the present embodiment, light of which waveguide mode has been scattered by a material for transparent electrode layer 13 low in reflectance viewed from light-emitting layer 14 can efficiently be extracted to a side of transparent substrate 10, which is desirable.

(Smooth Layer 12)

A transparent oxide semiconductor or a conductive resin exemplified as a material for transparent electrode layer 13 is desirably used for a material for smooth layer 12. When a transparent oxide semiconductor or a conductive resin exemplified as a material for transparent electrode layer 13 is used for a transparent dielectric layer, the transparent small-thickness metal layer and the transparent dielectric layer integrally function as transparent electrode layer 13, which advantageously leads to lowering in surface resistance and lessening of variation in in-plane luminance.

A general dielectric material can also be used. Examples of the dielectric material can include $TiO_2$ (having an refractive index n = 2.5) and $SiO_x$ (having an refractive index n = 1.4 to 3.5). Examples of other dielectric materials can include diamond, calcium fluoride (CaF), and silicon nitride ($Si_3N_4$).

A commercially available glass material having an refractive index n from 1.4 to 1.8 has been known as a glass material which can be used for a transparent member. Examples of a resin material include vinyl chloride, acrylic, polyethylene, polypropylene, polystyrene, ABS, nylon, polycarbonate, polyethylene terephthalate, polyvinylidene difluoride, Teflon™, polyimide, and a phenol resin, and there are also resin materials having an refractive index n from 1.4 to 1.8.

There are also techniques for controlling an refractive index to be higher or lower by mixing nanoparticles, and a plastic material in which hollow nano-silica has been mixed can have an refractive index n close to 1. By mixing light scattering particles 11b of a material high in refractive index such as $TiO_2$ in a resin, an refractive index n close to 2 can also be realized.

In addition, a method of controlling an refractive index of a transparent member includes a method of using a photonic crystal having a periodic structure of a dielectric or using a plasmonic crystal provided with a small metal structure.

A thickness d of smooth layer 12 defined as a distance from a maximum height of protrusion of light scattering particle 11b to transparent electrode layer 13 preferably satisfies an (expression 8) below, where λ [nm] represents an emission wavelength and Ns represents an refractive index of smooth layer 12 at the emission wavelength.

$$d < 2\lambda/Ns \quad ... \text{(Expression 8)}$$

In general, a spreading width of light in the waveguide mode is concentrated in a region having a length approximately twice as long as a wavelength in a propagation region. By satisfying the condition described in the expression (8), energy of light in the waveguide mode can efficiently be scattered by light scattering particles 11b.

(Light Scattering Particles 11b)

A material exemplified for smooth layer 12 can be used as a material for light scattering particles 11b. Examples of a substance with which light scattering particles 11b are easily formed include $TiO_2$ (having an refractive index n = 2.5) and $SiO_x$ (having an refractive index n = 1.4 to 3.5). Regarding a construction of light scattering layer 11, as shown in Fig. 14, desirably, light scattering particles 11b are higher in refractive index than smooth layer 12 and light scattering particles 11b protrude from binder 11a into smooth layer 12.

With such a construction, light scattering particles 11b function as if they were a waveguide core layer, and the light scattering particles have a function to carry energy of light in the waveguide mode toward transparent substrate 10 and to improve efficiency in extraction of light.

Referring again to Fig. 13, electroluminescent device (surface emitting device) 1 includes transparent substrate 10, light scattering layer 11, smooth layer 12, a transparent conductive layer, and light emitting layer 14. Light scattering layer 11 is formed of light scattering particles 11b and binder 11a, and each of a plurality of light scattering particles 11b is bonded by binder 11a such that projected two-dimensional area S1) when light scattering particles 11b are viewed in direction PL of the surface normal to the main surface of light emitting layer 14 is greater than whole-circumference average area S2 when light scattering particles 11b are viewed in the direction orthogonal to direction PL of the surface normal to the main surface of light emitting layer 14.

Thus, a ratio of light scattering particles 11b of which major axes are at an angle not smaller than 45 degrees with respect to the surface normal to the surface of light emitting layer 14 is higher than a ratio of light scattering particles 11b of which major axes are at an angle smaller than 45 degrees, and light scattering particles 11b are higher in refractive index than smooth layer 12 and protrude into smooth layer 12.

Though light scattering particles 11b protrude directly into smooth layer 12 in Figs. 13 and 14, the effect of the present embodiment is exhibited also when binder 11a small in thickness remains on the surface of light scattering particles 11b so as to conform to a surface shape of light scattering particles 11b as shown in Fig. 15. A remaining thickness of binder 11a small in thickness is desirably smaller than 1/2 of a height of light scattering particles 11b for retaining an effect of scattering.

A shape shown in Fig. 11 and other shapes can be adopted as a shape of light scattering particles 11b.

By adopting such a shape for light scattering particles 11b, light in the waveguide mode which propagates in any direction in the plane can efficiently be scattered. For a greater area occupied in the plane, among the shapes shown in Fig. 11, (D) the rod shape, (F) the oval shape (the shape of the track field), and (B) the parallelepiped are desirably adopted. A shape having a sharp corner is more desirable than a shape having a rounded corner. By employing a shape having a sharp corner, a space frequency can be made higher and efficiency in scattering of light in the waveguide mode can be enhanced.

Though sizes or shapes of light scattering particles 11b may be distributed, a maximum size of the light scattering particles is desirably such that a height of light scattering particles 11b is not greater than a thickness of smooth layer 12. Here, a height of light scattering particle 11b is defined by a height at the time when the major axis of light scattering particle 11b is arranged in parallel to a reference surface, the light scattering particle is rotated around the major axis, and rotation is stopped at a height at which the light scattering particle is smallest in thickness.

A minimum size of light scattering particle 11b is desirably such that a height of light scattering particle 11b is not smaller than 1/10 of an emission wavelength in order to function as light scattering particle 11b. More specifically, an (expression 9) below is preferably satisfied, where d represents a thickness of smooth layer 12, λ represents an emission wavelength, Np represents an refractive index of light scattering particles 11b, and LB represents a length of the minor axis of light scattering particle 11b.

$$0.1 \times \lambda/Np < LB < d \qquad ... \text{(Expression 9)}$$

For example, an (expression 10) below is preferably satisfied, where a thickness of smooth layer 12 is set to 500 nm, light scattering particles 11b have an refractive index of 2.4 and an emission wavelength is set to 550 nm.

$$23 \text{ nm} < L3 < 500 \text{ nm} \qquad ... \text{(Expression 10)}$$

Length LA of the major axis of light scattering particle 11b is desirably shorter than a distance Lg of propagation of light in the waveguide mode, in terms of a frequency of scattering. By setting a length as such, light in the waveguide mode and a probability of scattering of light scattering particles 11b can be increased, which contributes to improvement in efficiency.

A distance of propagation of light in the waveguide mode can be calculated by using an existing method for analyzing light in the waveguide mode such as a transfer matrix method, a finite element method, a beam propagation method, and a finite-difference time-domain (FDTD) method. Since relation of LA > LB should be satisfied in order to fulfill the effect in the present embodiment, an (expression 11) below is preferably satisfied.

$$LB < LA < Lg \qquad ... \text{(Expression 11)}$$

Since the distance of propagation of light in the waveguide mode is normally approximately 20 $\mu$m, a condition of 23 nm < LB < LA < 20 $\mu$m is defined as a more specific desirable range of LA.

(Light Emitting Layer 14)

When an organic material is used for light emitting layer 14, the light emitting layer typically has an refractive index between 1.6 and 1.8 in a region of visible light. From a point of view of preferably obtaining improvement in external extraction quantum efficiency of a device or longer life of light emission, an organic metal complex as a material for an organic EL device is preferably used as a material for light emitting layer 14. Furthermore, a metal involved with formation of a complex is preferably any one metal belonging to group VIII to group X in the periodic table, Al, or Zn, and particularly preferably, transparent electrode layer 13 is composed of Ir, Pt, Al, or Zn.

(Reflective Electrode Layer 15)

A metal material exemplified as a material for the transparent small-thickness metal layer can be employed as a material for reflective electrode layer 15. In addition, a dielectric multi-layer mirror or a photonic crystal may be used for a reflection layer. When the dielectric multi-layer mirror or the photonic crystal is used for a reflection layer, plasmon loss in the reflection layer is advantageously eliminated.

(Fifth Embodiment: Method of Manufacturing Electroluminescent Device 1)

A method of manufacturing electroluminescent device 1 in the present embodiment will be described below. An example in which an organic emissive layer (an organic EL layer) which emits light in a region of visible light (having a wavelength from 400 nm to 800 nm) is employed as specific light emitting layer 14 will be described. The present embodiment is not limited to the organic EL which emits visible light, but is common to all electroluminescent devices in which light emitting layer 14 lies between transparent electrode layers 13. For example, the present embodiment may be directed, for example, to an inorganic electroluminescent device or a device which emits infrared light.

In electroluminescent device 1 in the present embodiment, a metal film having good electron injection capability as reflective electrode layer 15 and a small-thickness metal electrode as transparent electrode layer 13 are possible. In this case, transparent electrode layer 13 serves as the anode and the metal film as reflective electrode layer 15 serves as the cathode. Any fluorescent material and phosphorescent material which have been known as organic EL materials can be used for light emitting layer 14 lying between transparent electrode layer 13 and reflective electrode layer 15. As necessary, a hole transfer layer may be provided on the anode side of light emitting layer 14 or an electron transfer layer may be provided on the cathode side of light emitting layer 14.

Alq3 (having a thickness of 50 nm) and a hole transfer layer ($\alpha$-NPD having a thickness of 50 nm) which emit light at a central wavelength of 520 nm may be employed as materials for light emitting layer 14. Light emitting layer 14 has an average refractive index n of 1.8 at a wavelength of 520 nm.

An example of a material used for each member and an refractive index will be described in connection with a wavelength of 520 nm. A resin film (an acrylic resin) having an refractive index n = 1.5 as a resin substrate is employed for transparent substrate 10. Ag (having an refractive index n = 0.13 and an extinction coefficient $\kappa$ = 3.1) is employed for transparent electrode layer 13.

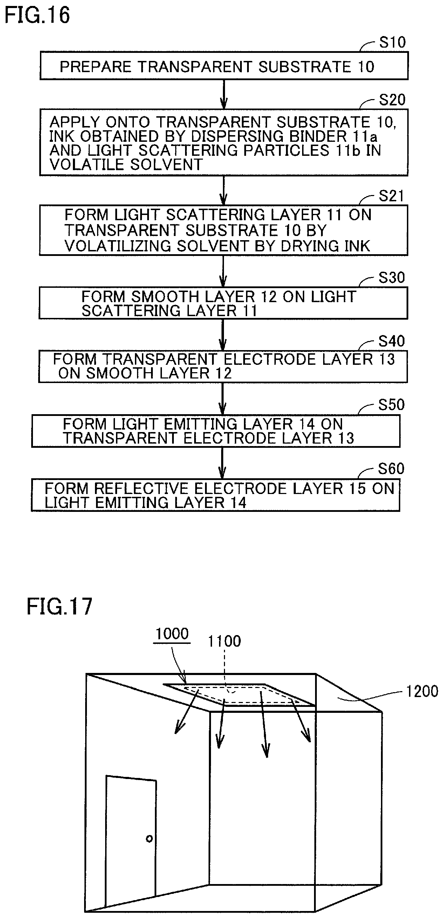

Referring to Fig. 16, in a specific step in the manufacturing method, a resin substrate having an refractive index n = 1.5 is prepared as transparent substrate 10 (S10). Light scattering layer 11 is formed on transparent substrate 10 with an ink-jet method (S20, 21). In forming light scattering layer 11 using the ink-jet method, an ink obtained by dispersing particles which contain columnar $TiO_2$ particles having rounded corners as light scattering particles 11b in a solvent is employed.

Lengths of the major axes of light scattering particles 11b are distributed from 50 nm to 500 nm. As a drying step is performed after application with ink-jet, the solvent is volatilized and light scattering layer 11 containing binder 11a and light scattering particles 11b is formed (S21).

The major axes of light scattering particles 11b are disposed in parallel to a substrate after volatilization, by setting a particle density such that a thickness of binder 11a after volatilization of the solvent is smaller than a thickness of the minor axes of light scattering particles 11b. This is because columnar particles are disposed in parallel (disposed horizontally) to the substrate owing to a moment produced by gravity.

Therefore, through the steps above, such a state that a ratio of light scattering particles 11b of which major axes are at an angle not smaller than 45 degrees with respect to the surface normal to the surface of light emitting layer 14 is higher than a ratio of particles of which major axes are at an angle smaller than 45 degrees can be created. By further adjusting a density of the ink, a ratio of an area occupied by a light scattering region in the plane of light scattering layer 11 can be higher than 90%. Here, a thickness of binder 11a in light scattering layer 11 after volatilization is set to 150 nm.

Smooth layer 12 having an refractive index of 1.85 is provided as smooth layer 12 on light scattering layer 11 (S30). A material having an refractive index of 1.85 by dispersing $TiO_2$ nanoparticles in a material for a hole transfer layer is used for a material for smooth layer 12. Smooth layer 12 has a thickness of 500 nm. The thickness of smooth layer 12 satisfies the condition in the expression (8).

As light scattering layer 11 is formed as above, light scattering particles 11b are densely arranged in light scattering layer 11. Here, when light scattering particles 11b are sparsely arranged, smoothness of the surface of the smooth layer should be secured for prevention of electrical short-circuiting due to discontinuity in the transparent electrode or the light emitting layer. To that end, a space among light scattering particles 11b should be filled with a material for smooth layer 12, and hence a material required for smooth layer 12 increases. In the present embodiment, light scattering particles 11b are densely arranged. Therefore, a material for smooth layer 12 for filling a space among light scattering particles 11b may be small. Consequently, an amount of a resin for filling in smooth layer 12 formed on light scattering layer 11 can be decreased and increase in manufacturing cost can be suppressed. For prevention of electrical short-circuiting in the transparent electrode or the light emitting layer, average surface roughness Ra of the smooth layer is smaller than 100 nm, preferably smaller than 30 nm, particularly preferably smaller than 10 nm, and most preferably smaller than 5 nm. Average surface roughness Ra refers to average roughness Ra in a square region having a size of 10 $\mu$m $\times$ 10 $\mu$m, which is measured with atomic force microscopy (AFM).

An Ag small-thickness film having a thickness of 10 nm is provided as transparent electrode layer 13 on smooth layer 12 (S40), and $\alpha$-NPD (50 nm) and Alq3 (50 nm) as light emitting layer 14 are successively stacked on transparent electrode layer 13 (S50). $\alpha$-NPD is stacked as a hole transfer layer between transparent electrode layer 13 and Alq3. An Ag film as reflective electrode layer 15 is formed to a thickness of 100 nm on light emitting layer 14 (on Alq3) (S60). Electroluminescent device 1 in the present embodiment is thus formed.

Electroluminescent device 1 described through each embodiment realizes high efficiency in extraction of light by selectively scattering light confined due to total reflection by increasing a ratio of the major axes of light scattering particles 11b being disposed in parallel to light emitting layer 14. A lighting apparatus including such electroluminescent device 1 can realize even light emission at high efficiency.

(Sixth Embodiment)

A lighting apparatus 1000 including electroluminescent device 1 including the construction shown in each embodiment will be described below. Fig. 17 shows a schematic construction of lighting apparatus 1000 in the present embodiment. Lighting apparatus 1000 in the present embodiment is a ceiling lighting apparatus including electroluminescent device 1 on a ceiling 1200 of a room.

Lighting apparatus 1000 in the present embodiment has a small thickness and can realize uniform light emission at various angles. Therefore, the lighting apparatus can provide a soft effect of a space. Since light is emitted at various angles, an effect that less shadow is cast is obtained.

Limitation to use as the ceiling lighting apparatus is not intended, and for example, the electroluminescent device in the present embodiment can be employed in various lighting apparatuses such as a floor lamp.

(Examples)

An refractive index of each layer in electroluminescent device 1 will be described below as Examples. A structure including light scattering layer 11 and smooth layer 12 as being combined will be called an "internal light extraction layer" below.

(Refractive Index)

Smooth layer 12 has an refractive index at a wavelength of 550 nm within a range not lower than 1.7 and lower than 2.5. Light in the waveguide mode confined in light emitting layer 14 of an organic light emitting device or light in the plasmon mode reflected from the cathode is light in a specific optical mode, and in order to extract such light, an refractive index not lower than 1.7 is required.

Even in a mode on a side of the highest order of the plasmon mode, light in a region not lower than an refractive index of 2.5 does not substantially exist, and a quantity of light which can be extracted will not increase even though an refractive index is equal or higher than that. In the present embodiment, an refractive index can be measured with a multi-wavelength Abbe refractometer, a prism coupler, a Michelson interferometer, or a spectroscopic ellipsometer.

(Haze Value of Internal Light Extraction Layer)

The internal light extraction layer has a Haze value (a ratio of a scattering transmittance to a total luminous transmittance) not lower than 20%, more preferably not lower than 25%, and particularly preferably not lower than 30%. When the Haze value is not lower than 20%, luminous efficiency can be improved.

The Haze value is a value representing a physical property calculated under (i) the influence by a difference in refractive index between compositions in the film and (ii) the influence by a surface shape. In the present Example, a Haze value of the internal light extraction layer in which smooth layer 12 is stacked on light scattering layer 11 is measured. Namely, a Haze value with the influence (ii) being excluded is determined by determining a Haze value with average surface roughness Ra at 10 $\mu$m being suppressed to a value smaller than 100 nm.

The internal light extraction layer in the present Example has a transmittance preferably not lower than 50%, more preferably not lower than 55%, and particularly preferably not lower than 60%.

(Refractive Index of Light Scattering Layer 11)

Light scattering layer 11 is a layer improving efficiency in extraction of light, and formed on an outermost surface of transparent substrate 10 on a side of transparent electrode layer 13. Light scattering layer 11 is constituted of a layer medium and light scattering particles (particles high in refractive index) 11b contained in the layer medium. A difference in refractive index between binder 11a (a resin material) representing a layer medium and contained light scattering particles 11b is not smaller than 0.03, preferably not smaller than 0.1, more preferably not smaller than 0.2, and particularly preferably not smaller than 0.3.

When a difference in refractive index between binder 11a and light scattering particles 11b is not smaller than 0.03, an effect of scattering is produced at an interface between binder 11a and light scattering particles 11b. As the difference in refractive index is larger, preferably, refraction at the interface is greater and the effect of scattering is improved.

Finally, smooth layer 12 is formed on light scattering layer 11. Light scattering layer 11 is a layer diffusing light based on a difference in refractive index between binder 11a representing the layer medium and light scattering particles 11b and on a difference in refractive index between light scattering particles 11b and smooth layer 12. Therefore, transparent particles having a size not smaller than a region causing Mie scattering in a visible light region are preferred as contained light scattering particles 11b, and the particles have an average particle size preferably not smaller than 0.2 $\mu$m.

In connection with the upper limit of the average particle size, when light scattering particles 11b are greater, a thickness of smooth layer 12 which smoothens roughness of light scattering layer 11 containing light scattering particles 11b should also be increased, which is disadvantageous from a point of view of load caused in a step and absorption in a film. Therefore, the upper limit of the average particle size is preferably smaller than 10 $\mu$m, more preferably smaller than 5 $\mu$m, particularly preferably smaller than 3 $\mu$m, and most preferably smaller than 1 $\mu$m.

An average particle size of light scattering particles 11b can be measured, for example, with an apparatus making use of dynamic light scattering such as Nanotrac UPA-EX150 manufactured by Nikkiso Co., Ltd. or with image processing of an electron micrograph.

Such light scattering particles 11b are not particularly restricted, and light scattering particles can be selected as appropriate depending on a purpose. Organic fine particles or inorganic fine particles may be applicable. Among these, inorganic fine particles high in refractive index are preferred.

Examples of the organic fine particles high in refractive index include polymethyl methacrylate beads, acryl-styrene copolymer beads, melamine beads, polycarbonate beads, styrene beads, cross-linked polystyrene beads, polyvinyl chloride beads, and benzoguanamine-melamine-formaldehyde beads.

Examples of the inorganic fine particles high in refractive index include inorganic oxide particles composed of an oxide of at least one selected from among zirconium, titanium, aluminum, indium, zinc, tin, and antimony. Examples of the inorganic oxide particles specifically include $ZrO_2$, $TiO_2$, $BaTiO_3$, $Al_2O_3$, $In_2O_3$, ZnO, $SnO_2$, $Sb_2O_3$, ITO, $SiO_2$, $ZrSiO_4$, and zeolite. Among these, $TiO_2$, $BaTiO_3$, $ZrO_2$, ZnO, and $SnO_2$ are preferred and $TiO_2$ is most preferred. Of $TiO_2$, a rutile type is more preferable than an anatase type, because the rutile type is lower in catalyst activity, provides higher weather resistance to a layer high in refractive index or a layer adjacent thereto, and is higher in refractive index than the anatase type.

Whether or not to subject light scattering particles 11b to a surface treatment can be selected from a point of view of improvement in dispersibility or stability when a dispersion liquid which will be described later is prepared in order to contain light scattering particles 11b in light scattering layer 11.

When the surface treatment is performed, examples of a specific material for the surface treatment include a heterogeneous inorganic oxide such as a silicon oxide or a zirconium oxide, a metal hydroxide such as an aluminum hydroxide, and an organic acid such as organosiloxane and a stearic acid. One type of such a surface treatment material may be used alone or a plurality of types may be used as being combined. From a point of view of stability of a dispersion liquid, as a surface treatment material, a heterogeneous inorganic oxide and/or a metal hydroxide are/is preferred and a metal hydroxide is more preferred.

When inorganic oxide particles are subjected to a surface coating treatment with a surface treatment material, an amount of coating (in general, an amount of coating being expressed as a mass ratio of a surface treatment material used for the surface of the particles to a mass of the particles) is preferably from 0.01 to 99 mass %. When an amount of coating with the surface treatment material is too small, an effect of improvement in dispersibility or stability resulting from the surface treatment cannot sufficiently be obtained. When an amount of coating is too large, an refractive index of mixed light scattering layer 11 high in refractive index is lowered, which is not preferred.

In addition, quantum dots described in WO2009/014707 and United States Patent No. 6608439 can also suitably be used as a material for particles high in refractive index.

The particles high in refractive index have an refractive index not lower than 1.7, preferably not lower than 1.85, and particularly preferably not lower than 2.0. When the refractive index is lower than 1.7, a difference in refractive index from binder 11a decreases, an amount of scattering decreases, and an effect of improvement in efficiency in extraction of light may not be obtained.

The upper limit of the refractive index of the particles high in refractive index is lower than 3.0. With a greater difference in refractive index from binder 11a, a sufficient amount of scattering can be obtained and an effect of improvement in efficiency in extraction of light is obtained.

The particles high in refractive index are preferably arranged to a thickness of one layer of light scattering particles 11b such that light scattering particles 11b are in contact with or in proximity to the interface between light scattering layer 11 and smooth layer 12. Thus, evanescent light which is exuded into mixed light scattering layer 11 when total reflection occurs in smooth layer 12 can be scattered by light scattering particles 11b and efficiency in extraction of light is improved.

When there are particles high in refractive index in an area beyond the average particle size thereof (for example, a thickness of light scattering layer 11 being 1.3 times as large as the average particle size of the particles high in refractive index), light scattering particles 11b are present at a position distant from the interface. Consequently, the light scattering particles do not scatter evanescent light and do not contribute to improvement in efficiency in extraction of light. When a thickness of distribution of light scattering particles 11b increases, such problems as lowering in uniformity in application or smoothness of the interface or lowering in representation performance due to increase in reflected and scattered light may arise.

A content of the particles high in refractive index in light scattering layer 11 is preferably within a range from 1.0 to 70% and more preferably within a range from 5 to 50% expressed as a volume filling factor. Thus, a distribution of indices of refraction can be sparse or dense at the interface between light scattering layer 11 and smooth layer 12, an amount of scattering of light can be increased, and efficiency in extraction of light can be improved.

When binder 11a representing a layer medium is made of a resin material, light scattering layer 11 is formed, for example, by dispersing light scattering particles 11b in a resin material (polymer) solution serving as a medium (a solvent not dissolving the particles being used) and applying the solution onto transparent substrate 10.

Since light scattering particles 11b are actually polydisperse particles and it is actually difficult to regularly arrange light scattering particles 11b, light scattering particles 11b achieve improvement in efficiency of extraction of light by changing a direction of light mostly by diffusion, although they locally have a diffraction effect.

(Examples of Binder 11a)

Known resins can be used for binder 11a without particularly being restricted, and specific examples thereof include a film of a resin such as acrylic acid ester, methacrylic acid ester, polyethylene terephthalate (PET), polybutylene terephthalate, polyethylene naphthalate (PEN), polycarbonate (PC), polyarylate, polyvinyl chloride (PVC), polyethylene (PE), polypropylene (PP), polystyrene (PS), nylon (Ny), aromatic polyamide, polyether ether ketone, polysulfone, polyether sulfone, polyimide, and polyether imide, a heat-resistant transparent film having silsesquioxane, polysiloxane, polysilazane, or polysiloxazane as a basic skeleton which has an organic-inorganic hybrid structure (such as a trademark Sila-DEC manufactured by Chisso Corporation), a perfluoroalkyl-group-containing silane compound (for example, (heptadecafluoro-1,1,2,2-tetradecyl)triethoxysilane), and a fluorine-containing copolymer having a fluorine-containing monomer and a monomer for providing a cross-linking group as a constitutional unit. Two or more of these resins can be used as being mixed. Among these, a resin having an organic-inorganic hybrid structure is preferred.

A hydrophilic resin below can also be employed. Examples of the hydrophilic resin include a water soluble resin, a resin dispersible in water, a colloidal dispersion resin, or a mixture thereof. Examples of the hydrophilic resin include an acrylic resin, a polyester based resin, a polyamide based resin, a polyurethane based resin, and a fluorine based resin. The examples of the resin include polymers such as polyvinyl alcohol, gelatin, polyethylene oxide, polyvinylpyrrolidone, casein, starch, agar, carrageenan, polyacrylic acid, polymethacrylic acid, polyacrylamide, polymethacrylamide, polystyrene sulfonic acid, cellulose, hydroxyethylcellulose, carboxymethylcellulose, hydroxyethylcellulose, dextran, dextrin, pullulan, and watersoluble polyvinyl butyral. Among these, polyvinyl alcohol is preferred.

One type of polymers may be used alone and two or more types may be used as being as mixed as necessary, as the polymer used for binder 11a. Similarly, conventionally known resin particles (an emulsion) can also suitably be used. A resin mainly cured by ultraviolet rays or election beams, that is, a mixture of a solvent and an ionizing radiation curable resin and a thermoplastic resin, or a thermosetting resin, can also suitably be used for binder 11a.

As a resin used for such binder 11a, a polymer having saturated hydrocarbon or polyether as a main chain is preferred and a polymer having a saturated hydrocarbon as a main chain is further preferred.

Binder 11a is preferably cross-linked. A polymer having saturated hydrocarbon as a main chain is preferably obtained through a polymerization reaction of an ethylenic unsaturated monomer. In order to obtain cross-linked binder 11a, a monomer having two or more ethylenic unsaturated groups is preferably employed.

In the present Example, a compound which can form a metal oxide, a metal nitride, or a metal oxynitride through irradiation with ultraviolet rays in a specific atmosphere is particularly suitably employed. A compound which can be reformed at a relatively low temperature described in Japanese Laid-Open Patent Publication No. 8-112879 is preferred as a compound suitable in the present Example.

Specifically, examples of the compound include polysiloxane having an Si-O-Si bond (including polysilsesquioxane), polysilazane having an Si-N-Si bond, and polysiloxazane including both of an Si-O-Si bond and an Si-N-Si bond. Two or more of these can be used as being mixed. Different compounds can sequentially or simultaneously be stacked.

<Polysiloxane>

Polysiloxane used in the present Example can contain $[R_3SiO_{1/2}]$, $[R_2SiO]$, $[RSiO_{3/2}]$, and $[SiO_2]$ as a general structural unit. R is independently selected from the group consisting of a hydrogen atom, an alkyl group containing 1 to 20 carbon atoms (for example, methyl, ethyl, or propyl), an aryl group (for example, phenyl), and an unsaturated alkyl group (for example, vinyl).

Examples of a specific polysiloxane group include $[PhSiO_{3/2}]$, $[MeSiO_{3/2}]$, $[HSiO_{3/2}]$, $[MePhSiO]$, $[Ph_2SiO]$, $[PhViSiO]$, $[ViSiO_{3/2}]$ (Vi representing a vinyl group), $[MeHSiO]$, $[MeViSiO]$, $[Me_2SiO]$, and $[Me_3SiO_{1/2}]$. A mixture or a copolymer of polysiloxane can also be used.

<Polysilsesquioxane>

In the present Example, polysilsesquioxane among polysiloxanes described above is preferably used. Polysilsesquioxane is a compound containing silsesquioxane in a structural unit. "Silsesquioxane" is a compound expressed as $[RSiO_{3/2}]$, and it is normally polysiloxane synthesized as a result of hydrolysis-polycondensation of an $RSiX_3$ type compound (R representing a hydrogen atom, an alkyl group, an alkenyl group, an aryl group, or an aralkyl group, and X representing halogen or an alkoxy group).

Representatively, an amorphous structure, a ladder structure, a polyhedral structure, and a partially cleaved structure thereof (a polyhedral structure from which one silicon atom is missing or a polyhedral structure in which silicon-oxygen bond is partially cut) have been known as a shape of a molecular sequence of polysilsesquioxane.

Among polysilsesquioxanes, what is called a hydrogen silsesquioxane polymer is preferably employed. Examples of a hydrogen silsesquioxane polymer include a hydride siloxane polymer expressed as $HSi(OH)_x(OR)_yO_{z/2}$. Each R represents an organic group or a substituted organic group, and forms a hydrolyzable substituent when it is bonded to silicon by an oxygen atom. Relation of x = 0 to 2, y = 0 to 2, z = 1 to 3, and x+y+z = 3 is satisfied.

Examples of R include an alkyl group (for example, methyl, ethyl, propyl, or butyl), an aryl group (for example, phenyl), and an alkenyl group (for example, aryl or vinyl). These resins can completely be condensed $(HSiO_{3/2})_n$, or only partially be hydrolyzed (that is, containing Si-OR in part), and/or partially condensed (that is, containing Si-OH in part).

<Polysilazane>

Polysilazane used in the present Example is a polymer having silicon-nitrogen bond and an inorganic precursor polymer, such as $SiO_2$, $Si_3N_4$, and $SiO_xN_y$ which is an intermediate solid solution of both of the former (x being 0.1 to 1.9 and y being 0.1 to 1.3) and is composed of Si-N, Si-H, or N-H.

Polysilazane preferably used in the present Example is expressed in a general formula (A) below.

$$\text{General Formula (A)} \qquad -[Si(R_1)(R_2)-N(R_3)]-$$

In the present Example, from a point of view of denseness, perhydropolysilazane in which all of R1, R2, and R3 are hydrogen atoms is particularly preferred.

An ionizing radiation curable resin composition as binder 11a can be cured with a normal method of curing an ionizing radiation curable resin composition, that is, irradiation with electron beams or ultraviolet rays.

For example, in curing with electron beams, electron beams having energy from 10 to 1000 keV or preferably 30 to 300 keV emitted from various electron accelerators of a Cockroft Walton type, a Van de Graaff type, a resonance transformation type, an insulated core transformer type, a linear type, a dynamitron type, or a high frequency type are used. In curing with ultraviolet rays, ultraviolet rays emitted from light rays of an ultrahigh-pressure mercury lamp, a high-pressure mercury lamp, a low-pressure mercury lamp, a carbon arc, a xenon arc, and a metal halide lamp can be made use of.

<Vacuum Ultraviolet Ray Irradiation Apparatus Having Excimer Lamp>

A noble gas excimer lamp which emits vacuum ultraviolet rays from 100 to 230 nm is specifically exemplified as a preferred ultraviolet ray irradiation apparatus according to the present Example. Since an atom of a noble gas such as Xe, Kr, Ar, or Ne does not chemically bond to form a molecule, such a gas is called an inert gas. An atom of the noble gas which has obtained energy as a result of discharging (an excited atom) can bond to another atom to be able to form a molecule.

For example, when xenon (Xe) is adopted as the noble gas, excimer light at 172 nm is emitted when $Xe_2^*$ representing an excited excimer molecule makes transition to a ground state, as shown in a reaction formula below.

$$e + Xe \rightarrow Xe^*$$

$$Xe^* + 2Xe \rightarrow Xe_2^* + Xe$$

$$Xe_2^* \rightarrow Xe + Xe + h\nu \ (172 \ nm)$$

The excimer lamp is characterized by high efficiency because radiation is concentrated at one wavelength and substantially no light except for necessary light is radiated. Since no extra light is radiated, a temperature of an object can be kept at a relatively low temperature. Furthermore, since it does not take time to activate and activate again the excimer lamp, the excimer light can instantaneously be turned on and blink.

A dielectric barrier discharge lamp is exemplified as a light source which efficiently emits excimer light. The dielectric barrier discharge lamp causes discharge between electrodes with a dielectric being interposed, and generally, at least one electrode should only be arranged in a discharge vessel composed of a dielectric and the outside thereof.

For example, a dielectric barrier discharge lamp in which a noble gas such as xenon is sealed in a discharge vessel in a form of a double-wall cylinder constituted of a thick pipe and a thin pipe made of quartz glass, a first electrode in a form of a mesh is provided outside the discharge vessel, and another electrode is provided in an inner pipe is available. The dielectric barrier discharge lamp emits excimer light by causing dielectric barrier discharge in the discharge vessel by applying a high-frequency voltage across electrodes so as to dissociate excimer molecules such as xenon generated by the discharge.

Since the excimer lamp is high in efficiency in emission of light, it can be turned on with low power. Since the excimer lamp does not emit light having a long wavelength which becomes a factor for increase in temperature but emits energy at a single wavelength in an ultraviolet region, it is characterized by ability to suppress increase in temperature of an object to be irradiated with irradiation light itself

(Smooth Layer 12)

Smooth layer 12 is preferably a layer having a high refractive index not lower than 1.7 and lower than 2.5. So long as an refractive index is not lower than 1.7 and lower than 2.5, the smooth layer may be formed of a single material or of a mixture. How to define an refractive index in forming the smooth layer of a mixture is the same as in the case of light scattering layer 11.

It is important for smooth layer 12 to have flatness which allows satisfactory formation of transparent electrode layer 13 thereon. The surface has average surface roughness Ra smaller than 100 nm, preferably smaller than 30 nm, particularly preferably smaller than 10 nm, and most preferably smaller than 5 nm. Average surface roughness Ra refers to average surface roughness Ra in a 10-$\mu$m $\square$ measured with atomic force microscopy (AFM).

A resin similar to that for binder 11a of light scattering layer 11 is exemplified as a resin used for smooth layer 12. A fine particle sol is preferred as a material high in refractive index to be contained in smooth layer 12. The lower limit of the refractive index of metal oxide fine particles contained in smooth layer 12 high in refractive index is preferably not lower than 1.7, more preferably not lower than 1.85, further preferably not lower than 2.0, and particularly preferably not lower than 2.5, in a bulk state.

The upper limit of the refractive index of the metal oxide fine particles is preferably not higher than 3.0. When the metal oxide fine particles have an refractive index lower than 1.7, the effect aimed by the present embodiment is lessened, which is not preferred. When the metal oxide fine particles have an refractive index higher than 3.0, multiple scattering in a film increases and transparency is lowered, which is not preferred.

The lower limit of a particle size of the metal oxide fine particles (inorganic particles) contained in smooth layer 12 high in refractive index is normally preferably not smaller than 5 nm, more preferably not smaller than 10 nm, and further preferably not smaller than 15 nm. The upper limit of a particle size of the metal oxide fine particles is preferably not greater than 70 nm, more preferably not greater than 60 nm, and further preferably not greater than 50 nm.

When the metal oxide fine particles have a particle size smaller than 5 nm, the metal oxide fine particles tend to aggregate and transparency is lowered to the contrary, which is not preferred. When a particle size is small, a surface area increases, a catalyst activity is enhanced, and deterioration of smooth layer 12 or a layer adjacent thereto may be accelerated, which is not preferred. When the metal oxide fine particles have a particle size greater than 70 nm, transparency of smooth layer 12 lowers, which is not preferred. So long as the effect of the present embodiment is not impaired, a distribution of the particle size is not restricted, the distribution may be wide or narrow, or there may be a plurality of distributions.

The lower limit of a content of the metal oxide fine particles in smooth layer 12 is preferably not lower than 70 mass %, more preferably not lower than 80 mass %, and further preferably not lower than 85 mass %, with respect to the total mass. The upper limit of a content of the metal oxide fine particles is preferably not higher than 97 mass % and more preferably not higher than 95 mass %. When a content of the metal oxide fine particles in smooth layer 12 is lower than 70 mass %, it becomes substantially difficult for smooth layer 12 to have an refractive index not lower than 1.80. When a content of the metal oxide fine particles in smooth layer 12 is higher than 95 mass %, application of smooth layer 12 becomes difficult, brittleness of a film after drying is also high, and resistance to bending is lowered, which is not preferred.

$TiO_2$ (a titanium dioxide sol) is more preferred as the metal oxide fine particles contained in smooth layer 12 in the present embodiment from a point of view of stability. Of $TiO_2$, in particular, a rutile type is more preferable than an anatase type, because the rutile type is lower in catalyst activity, provides higher weather resistance to smooth layer 12 or a layer adjacent thereto, and is higher in refractive index than the anatase type.

For example, Japanese Laid-Open Patent Publications Nos. 63-17221, 7-819, 9-165218, and 11-43327 can be refereed to for a method of preparing a titanium dioxide sol. A preferred primary particle size of titanium dioxide fine particles is within a range from 5 to 15 nm and more preferably within a range from 6 to 10 nm.

(Transparent Substrate 10)

For example, glass or plastic can be exemplified for transparent substrate 10 in which an internal light extraction layer is formed, however, limitation thereto is not intended. Examples of preferably used transparent substrate 10 can include glass, quartz, and a transparent resin film.

Examples of glass include silica glass, soda lime silica glass, lead glass, borosilicate glass, and alkali free glass. From a point of view of adhesion to light scattering layer 11, durability, and smoothness, a surface of such a glass material may be subjected to a physical treatment such as polishing as necessary, or a coating composed of an inorganic substance or an organic substance or a hybrid coating which is a combination of these coatings may be formed on a surface of the glass material.

Examples of the resin film include polyester such as polyethylene terephthalate (PET) and polyethylene naphthalate (PEN), polyethylene, polypropylene, cellulose esters or derivatives thereof such as cellophane, cellulose diacetate, cellulose triacetate (TAC), cellulose acetate butyrate, cellulose acetate propionate (CAP), cellulose acetate phthalate, and cellulose nitrate, polyvinylidene chloride, polyvinyl alcohol, polyethylene vinyl alcohol, syndiotactic polystyrene, polycarbonate, a norbornene resin, polymethylpentene, polyether ketone, polyimide, polyether sulfone (PES), polyphenylene sulfide, polysulfones, polyetherimide, polyether ketone imide, polyamide, a fluorine resin, nylon, polymethyl methacrylate, acrylic or polyarylates, and a cycloolefin based resin such as Arton® (trademark manufactured by JSR Corporation) or Apel™ (trademark manufactured by Mitsui Chemicals, Inc.).

A coating composed of an inorganic substance or an organic substance or a hybrid coating which is a combination of these coatings may be formed on a surface of the resin film. Such a coating and a hybrid coating are each preferably a gas barrier film (also called a barrier film) having a water vapor permeability ($25\pm0.5°C$, relative humidity $90\pm2\%$ RH) not higher than 0.01 $g/(m^2•24\ h)$ measured with a method in conformity with JIS K 7129-1992. Furthermore, the coating and the hybrid coating are each preferably a high gas barrier film having an oxygen permeability not higher than $1 \times 10^{-3}\ ml/(m^2•24h•atm)$ and a water vapor permeability not higher than $1 \times 10^{-5}\ g/(m^2•24h)$ which are measured with a method in conformity with JIS K 7126-1987.

A material having a function to suppress entry of a substance bringing about deterioration of a device, such as moisture or oxygen, should only be adopted as a material for forming the gas barrier film as above, and for example, silicon oxide, silicon dioxide, or silicon nitride or polysilazane described previously can be employed. Furthermore, in order to overcome weakness of the gas barrier film, a stack structure of such an inorganic layer and a layer composed of an organic material (an organic layer) is more preferably provided. Though an order of stack of the inorganic layer and the organic layer is not particularly restricted, they are preferably alternately stacked a plurality of times.

A method of forming a gas barrier film is not particularly limited, and for example, vacuum vapor deposition, sputtering, reactive sputtering, molecular beam epitaxy, cluster ion beam, ion plating, plasma polymerization, atmospheric plasma polymerization, plasma CVD, laser CVD, thermal CVD, or coating can be employed. Atmospheric plasma polymerization described in Japanese Laid-Open Patent Publication No. 2004-68143 or a method of reforming polysilazane (-containing liquid) by irradiating the same with vacuum ultraviolet rays having a wavelength from 100 to 230 nm is particularly preferred.

(Detailed Process for Manufacturing Light Scattering Layer 11 and Smooth Layer 12 (Internal Light Extraction Layer))

A detailed process for manufacturing light scattering layer 11 and smooth layer 12 (the internal light extraction layer) will now be described. Fig. 16 is referred to again. A substrate obtained by degreasing a transparent alkali free glass substrate having a thickness of 0.7 mm and a size of 60 mm x 60 mm, washing the glass substrate with ultrapure water, and drying the glass substrate with a clean dryer was prepared as transparent substrate 10 (S10).

Then, a prepared liquid for light scattering layer 11 was prescriptively designed by an amount of 10 ml, such that a ratio of a solid content between $TiO_2$ particles (JR600A manufactured by Tayca Corporation) having an refractive index of 2.4 and an average particle size of 0.25 $\mu$m and a resin solution (ED230AL (an organic-inorganic hybrid resin) manufactured by APM) was 70 vol %/30 vol %, a solvent ratio between n-propyl acetate and cyclohexanone was 10 wt %/90 wt %, and a solid content concentration was 15 wt %.

Specifically, a dispersion liquid of $TiO_2$ was prepared by mixing $TiO_2$ particles and a solvent while the mixture was cooled at a room temperature and dispersing the mixture for 10 minutes with an ultrasound disperser (UH-50 manufactured by SMT Co., Ltd.) under standard conditions for microchip steps (MS-3 having 3 mm$\phi$ manufactured by SMT Co., Ltd.).

Then, an application liquid of light scattering layer 11 was obtained by mixing and adding a resin little by little while the $TiO_2$ dispersion liquid was stirred at 100 rpm and mixing the mixture for 10 minutes with a stirring speed being raised to 500 rpm after completion of addition. Thereafter, the application liquid was filtered through a hydrophobic PVDF 0.45$\mu$m filter (manufactured by Whatman) and thus an aimed dispersion liquid was obtained.

Light scattering layer 11 having a thickness of 0.5 $\mu$m was formed (S21) by rotationally applying the dispersion liquid onto transparent substrate 10 by spin coating (500 rpm for 30 seconds) (S20), roughly drying the dispersion liquid (80°C for 2 minutes), and baking the dispersion liquid (120°C for 60 minutes).

Then, a prepared liquid for smooth layer 12 was prescriptively designed by an amount of 10 ml, such that a ratio of a solid content between a nano $TiO_2$ dispersion liquid (HDT-760T manufactured by Tayca Corporation) having an average particle size of 0.02 $\mu$m and a resin solution (ED230AL (an organic-inorganic hybrid resin) manufactured by APM) was 45 vol %/55 vol %, a solvent ratio between n-propyl acetate, cyclohexanone, and toluene was 20 wt %/30 wt %/50 wt %, and a solid content concentration was 20 wt %.

Specifically, an application liquid of smooth layer 12 was obtained by mixing the nano TiO$_2$ dispersion liquid and a solvent, mixing and adding a resin little by little while the dispersion liquid was stirred at 100 rpm, and mixing the mixture for 10 minutes with a stirring speed being raised to 500 rpm after completion of addition. Thereafter, the application liquid was filtered through a hydrophobic PVDF 0.45$\mu$m filter (manufactured by Whatman) and thus an aimed dispersion liquid was obtained.

The dispersion liquid was rotationally applied onto light scattering layer 11 by spin coating (500 rpm for 30 seconds) (S30). Thereafter, smooth layer 12 having a thickness of 0.7 $\mu$m was formed by roughly drying the dispersion liquid (80°C for 2 minutes), and baking the dispersion liquid (120°C for 30 minutes). Internal light extraction layer 1 was thus fabricated. A single film of smooth layer 12 had an refractive index of 1.85.

The internal light extraction layer fabricated as above had transmittance T of 67% and a Haze value Hz of 50%. An refractive index at a wavelength of 550 nm of the entire internal light extraction layer was measured with an ellipsometer of Sopra based on D542, and it was 1.85.

A surface and a cross-section of the internal light extraction layer (light scattering layer 11 and smooth layer 12) thus fabricated were analyzed with a reflection electron microscope (SEM) and a transmission electron microscope (TEM), and it was confirmed that the light scattering particles were bonded by the binder in the internal light extraction layer such that a projected average area when the light scattering particles were viewed in the direction of the surface normal to the main surface of light emitting layer 14 was greater than the whole-circumference average area when light scattering particles 11b were viewed in the direction orthogonal to the direction of the surface normal to the main surface of light emitting layer 14.

By separately observing a surface state with only light scattering layer 11 being provided, it was confirmed that a thickness of a region smallest in thickness of binder 11a of light scattering layer 11 was smaller than a height of a particle and some of particles protruded from binder 11a.

In fabrication of the internal light extraction layer, another internal light extraction layer was fabricated similarly except that the alkali free glass substrate was replaced with a PET film having gas barrier properties of the internal light extraction layer. It was confirmed that optical characteristics and a degree of orientation of particles were the same as in the internal light extraction layer which had previously been manufactured.

As described above, in connection with an electroluminescent device using electroluminescence, a lighting apparatus, and a method of manufacturing an electroluminescent device, a method of providing a scattering structure in an electroluminescent device for extracting light which cannot be extracted due to total reflection in the electroluminescent device has conventionally been known.

The conventional scattering structure, however, could not sufficiently extract light because such an effect remained that light which had not been confined due to total reflection was not successfully extracted because of having been scattered to the contrary. In the embodiment above, light scattering layer 11 containing light scattering particles 11b having the major axes (particles asymmetric in shape) is employed and a ratio of the major axes of light scattering particles 11b being disposed in parallel to light emitting layer 14 is raised so that light confined due to total reflection is selectively scattered and high efficiency in extraction of light can be realized.

The electroluminescent device described above includes the light emitting layer which emits light, the first electrode layer provided on the surface on one side of the light emitting layer, through which light emitted from the light emitting layer can pass, the second electrode layer provided on the surface on the other side of the light emitting layer, the smooth layer provided opposite to the side where the light emitting layer is provided, with the first electrode layer being interposed, the light scattering layer provided opposite to the side where the first electrode layer is provided, with the smooth layer being interposed, and the transparent substrate provided opposite to the side where the smooth layer is provided, with the light scattering layer being interposed.

The light scattering layer contains the binder provided on the side of the transparent substrate and a plurality of light scattering particles bonded by the binder and provided on the side of the smooth layer, and the plurality of light scattering particles are bonded by the binder such that a projected two-dimensional area when the light scattering particles are viewed in the direction of the surface normal to the main surface of the light emitting layer is greater than a whole-circumference average area when the light scattering particles are viewed in the direction orthogonal to the direction of the surface normal to the main surface of the light emitting layer.

In one embodiment, the light scattering layer contains a plurality of light scattering particles arranged such that some of the light scattering particles protrude from the binder into the smooth layer.

In one embodiment, in the surface of the light scattering layer, a ratio of an area occupied by the plurality of light scattering particles is not lower than 90%.

In one embodiment, relation of Neff $\leq$ Ns and Ns < Np and Nb < Ns is satisfied, where Neff represents an effective refractive index of light in the waveguide mode which propagates through the light emitting layer at an emission wavelength in the absence of the light scattering layer and the smooth layer, Ns represents an refractive index of the smooth layer at the emission wavelength, Np represents an refractive index of the light scattering particles, and Nb represents an refractive index of the binder.

The lighting apparatus described above includes the electroluminescent device described in any portion above.

The method of manufacturing an electroluminescent device described above includes the steps of preparing the transparent substrate having the main surface, forming the light scattering layer on the main surface, forming the smooth layer on the light scattering layer, forming on the smooth layer, the first electrode layer through which light can pass, forming the light emitting layer on the first electrode layer, and forming the second electrode layer on the light emitting layer.

The step of forming the light scattering layer includes the steps of applying an ink obtained by dispersing a binder and a plurality of light scattering particles in a volatile solvent to the main surface of the transparent substrate and volatilizing the solvent by drying the ink and bonding each of the plurality of light scattering particles with the binder such that a projected two-dimensional area when the light scattering particles are viewed in the direction of the surface normal to the main surface of the light emitting layer is greater than a whole-circumference average area when the light scattering particles are viewed in the direction orthogonal to the direction of the surface normal to the main surface of the light emitting layer.

As described above, an electroluminescent device, a lighting apparatus, and a method of manufacturing an electroluminescent device which allow improvement in luminous efficiency of the electroluminescent device by efficiently scattering light in a waveguide mode in the electroluminescent device are provided.

Though the electroluminescent device, the lighting apparatus, and the method of manufacturing an electroluminescent device in each of the embodiments and the examples of the present embodiment have been described, it should be understood that the embodiments disclosed herein are illustrative and non-restrictive in every respect. Therefore, the scope of the present invention is defined by the terms of the claims and is intended to include any modifications within the scope and meaning equivalent to the terms of the claims.

REFERENCE SIGNS LIST

1 electroluminescent device; 10 transparent substrate; 11 light scattering layer; 11a binder; 11b light scattering particles; 12 smooth layer; 13 transparent electrode layer (first electrode layer); 14 light emitting layer; 15 reflective electrode layer (second electrode layer); LA major axis; LB minor axis; and PL surface normal.

**Claims**

1. An electroluminescent device comprising:

   a light emitting layer which emits light;
   a first electrode layer provided on a surface on one side of the light emitting layer, through which light emitted from the light emitting layer can pass;
   a second electrode layer provided on a surface on the other side of the light emitting layer;
   a smooth layer provided opposite to a side where the light emitting layer is provided, with the first electrode layer being interposed;
   a light scattering layer provided opposite to a side where the first electrode layer is provided, with the smooth layer being interposed; and
   a transparent substrate provided opposite to a side where the smooth layer is provided, with the light scattering layer being interposed,
   the light scattering layer containing

      a binder provided on a side of the transparent substrate, and
      a plurality of light scattering particles bonded by the binder and provided on a side of the smooth layer,

   the plurality of light scattering particles being bonded by the binder such that a projected two-dimensional area when the light scattering particles are viewed in a direction of a surface normal to a main surface of the light emitting layer is greater than a whole-circumference average area when the light scattering particles are viewed in a direction orthogonal to the direction of the surface normal to the main surface of the light emitting layer.

2. The electroluminescent device according to claim 1, wherein the light scattering layer contains a plurality of the light scattering particles arranged such that some of the light scattering particles protrude from the binder into the smooth layer.

3. The electroluminescent device according to claim 1 or 2, wherein

in a surface of the light scattering layer, a ratio of an area occupied by the plurality of light scattering particles is not lower than 90%.

4. The electroluminescent device according to any one of claims 1 to 3,
wherein
relation of Neff ≤ Ns and Ns < Np and Nb < Ns is satisfied, where Neff represents an effective refractive index of light in a waveguide mode which propagates through the light emitting layer at an emission wavelength in absence of the light scattering layer and the smooth layer, Ns represents an refractive index of the smooth layer at the emission wavelength, Np represents an refractive index of the light scattering particles, and Nb represents an refractive index of the binder.

5. A lighting apparatus comprising the electroluminescent device according to any one of claims 1 to 4.

6. A method of manufacturing an electroluminescent device, the method comprising the steps of:

preparing a transparent substrate having a main surface;
forming a light scattering layer on the main surface;
forming a smooth layer on the light scattering layer;
forming on the smooth layer, a first electrode layer through which light can pass;
forming a light emitting layer on the first electrode layer; and
forming a second electrode layer on the light emitting layer,
the step of forming a light scattering layer including the steps of

applying an ink obtained by dispersing a binder and a plurality of light scattering particles in a volatile solvent to the main surface of the transparent substrate,
and
volatilizing the solvent by drying the ink and bonding each of the plurality of light scattering particles with the binder such that a projected two-dimensional area when the light scattering particles are viewed in a direction of a surface normal to a main surface of the light emitting layer is greater than a whole-circumference average area when the light scattering particles are viewed in a direction orthogonal to the direction of the surface normal to the main surface of the light emitting layer.

FIG.1

15:REFLECTIVE ELECTRODE LAYER

14:LIGHT EMITTING LAYER

13:TRANSPARENT ELECTRODE LAYER

12:SMOOTH LAYER

11:LIGHT SCATTERING LAYER

10:TRANSPARENT SUBSTRATE

LIGHT

1

FIG.2

12:SMOOTH LAYER

11b:LIGHT SCATTERING PARTICLE

11a:BINDER

11:LIGHT SCATTERING LAYER

10:TRANSPARENT SUBSTRATE

FIG.3

PL

15:REFLECTIVE ELECTRODE
LAYER

14:LIGHT EMITTING LAYER

13:TRANSPARENT
ELECTRODE LAYER

12:SMOOTH LAYER

11b:LIGHT
SCATTERING
PARTICLE } 11:LIGHT
SCATTERING
11a:BINDER LAYER

10:TRANSPARENT
SUBSTRATE

B1

## FIG.4

15:REFLECTIVE ELECTRODE LAYER

14:LIGHT EMITTING LAYER

13:TRANSPARENT ELECTRODE LAYER

B2

12:SMOOTH LAYER

11b:LIGHT SCATTERING PARTICLE

11a:BINDER

11:LIGHT SCATTERING LAYER

10:TRANSPARENT SUBSTRATE

## FIG.5

FIG.6

PL

A

H

α

S1

FIG.7

PL

14

B

360°

α

H1

S2n

FIG.8

FIG.9

12:SMOOTH LAYER
11b:LIGHT SCATTERING PARTICLE
11a:BINDER
11:LIGHT SCATTERING LAYER
10:TRANSPARENT SUBSTRATE

FIG.10

# FIG.11

(A)

LA

(B)

LA

(C)

LA

(D)

LA

(E)

LA

(F)

LA

(G)

LA

(H)

LA

FIG.12

B1

PL

Neff≦Ns and Ns<Np and Nb<Ns

12:SMOOTH LAYER:REFRACTIVE
INDEX Ns

11b:LIGHT SCATTERING
PARTICLE:REFRACTIVE
INDEX Np

11a:BINDER:REFRACTIVE
INDEX Nb

11:LIGHT
SCATTERING
LAYER

10:TRANSPARENT SUBSTRATE

FIG.13

15:REFLECTIVE ELECTRODE
LAYER(Al,Ag,Ca,Cu)

14:LIGHT EMITTING LAYER
(α-NPD/Alq3)

13:TRANSPARENT ELECTRODE
LAYER(Al,Ag,Ca,Cu)

12:SMOOTH LAYER(TiO,SiOx
REFRACTIVE INDEX Ns)

11:LIGHT SCATTERING LAYER

10:RESIN FILM(REFRACTIVE
INDEX 1.5)

1

# FIG.14

THICKNESS
d OF SMOOTH
LAYER d

PL

13:TRANSPARENT ELECTRODE
LAYER

12:SMOOTH LAYER:REFRACTIVE
INDEX Ns

11b:LIGHT SCATTERING
PARTICLE:REFRACTIVE
INDEX Np

11a:BINDER:REFRACTIVE
INDEX Nb

11:LIGHT
SCATTERING
LAYER

10:TRANSPARENT SUBSTRATE

# FIG.15

THICKNESS
d OF SMOOTH
LAYER d

PL

13:TRANSPARENT ELECTRODE
LAYER

12:SMOOTH LAYER:REFRACTIVE
INDEX Ns

11b:LIGHT SCATTERING
PARTICLE:REFRACTIVE
INDEX Np

11a:BINDER:REFRACTIVE
INDEX Nb

11:LIGHT
SCATTERING
LAYER

10:TRANSPARENT SUBSTRATE

## FIG.16

**S10**
PREPARE TRANSPARENT SUBSTRATE 10

↓

**S20**
APPLY ONTO TRANSPARENT SUBSTRATE 10, INK OBTAINED BY DISPERSING BINDER 11a AND LIGHT SCATTERING PARTICLES 11b IN VOLATILE SOLVENT

↓

**S21**
FORM LIGHT SCATTERING LAYER 11 ON TRANSPARENT SUBSTRATE 10 BY VOLATILIZING SOLVENT BY DRYING INK

↓

**S30**
FORM SMOOTH LAYER 12 ON LIGHT SCATTERING LAYER 11

↓

**S40**
FORM TRANSPARENT ELECTRODE LAYER 13 ON SMOOTH LAYER 12

↓

**S50**
FORM LIGHT EMITTING LAYER 14 ON TRANSPARENT ELECTRODE LAYER 13

↓

**S60**
FORM REFLECTIVE ELECTRODE LAYER 15 ON LIGHT EMITTING LAYER 14

## FIG.17

## INTERNATIONAL SEARCH REPORT

| International application No. |
| --- |
| PCT/JP2015/056302 |

A. CLASSIFICATION OF SUBJECT MATTER
*H05B33/02*(2006.01)i, *G02B5/02*(2006.01)i, *H01L51/50*(2006.01)i, *H05B33/10*(2006.01)i, *H05B33/14*(2006.01)i, *H05B33/22*(2006.01)i

According to International Patent Classification (IPC) or to both national classification and IPC

B. FIELDS SEARCHED

Minimum documentation searched (classification system followed by classification symbols)
H05B33/02, G02B5/02, H01L51/50, H05B33/10, H05B33/14, H05B33/22

Documentation searched other than minimum documentation to the extent that such documents are included in the fields searched
Jitsuyo Shinan Koho          1922–1996   Jitsuyo Shinan Toroku Koho   1996–2015
Kokai Jitsuyo Shinan Koho    1971–2015   Toroku Jitsuyo Shinan Koho   1994–2015

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2013-539182 A  (LG Chem, Ltd.),<br>17 October 2013 (17.10.2013),<br>claim 3; paragraphs [0003] to [0004], [0010],<br>[0014], [0016] to [0020], [0034] to [0036],<br>[0056], [0059]; fig. 2<br>& US 2014/0014923 A1    & WO 2012/033322 A<br>& EP 2600431 A2         & KR 10-2012-0024358 A<br>& CN 103201869 A | 1-6 |
| Y | WO 2010/055773 A1  (Konica Minolta Opto, Inc.),<br>20 May 2010 (20.05.2010),<br>paragraphs [0053] to [0064], [0072] to [0075]<br>(Family: none) | 1-6 |

[X] Further documents are listed in the continuation of Box C.     [ ] See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 25 May 2015 (25.05.15) | 02 June 2015 (02.06.15) |

| Name and mailing address of the ISA/ | Authorized officer |
| --- | --- |
| Japan Patent Office<br>3-4-3,Kasumigaseki,Chiyoda-ku,<br>Tokyo 100-8915,Japan | |
| | Telephone No. |

Form PCT/ISA/210 (second sheet) (July 2009)

**INTERNATIONAL SEARCH REPORT**

| International application No. |
|---|
| PCT/JP2015/056302 |

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2010-212184 A  (Konica Minolta Opto, Inc.), 24 September 2010 (24.09.2010), paragraphs [0025] to [0057], [0068], [0093] (Family: none) | 1-6 |
| Y | JP 2010-161002 A  (Konica Minolta Opto, Inc.), 22 July 2010 (22.07.2010), paragraphs [0027] to [0057] (Family: none) | 1-6 |
| Y | JP 2012-186106 A  (Toshiba Corp.), 27 September 2012 (27.09.2012), paragraphs [0042], [0063], [0069], [0074] to [0075]; fig. 7 to 8 & US 2012/0228591 A1    & EP 2497810 A1 & CN 102683606 A        & KR 10-2012-0102534 A & TW 201304227 A | 3 |
| A | JP 2009-076452 A  (Panasonic Electric Works Co., Ltd.), 09 April 2009 (09.04.2009), paragraphs [0044], [0047] & US 2011/0024779 A1    & WO 2009/028456 A1 & EP 2203030 A1         & KR 10-2010-0063729 A & CN 101790899 A | 1-6 |

Form PCT/ISA/210 (continuation of second sheet) (July 2009)

EP 3 119 163 A1

REFERENCES CITED IN THE DESCRIPTION

**Patent documents cited in the description**

- JP 2009076452 A
- JP 2012069277 A
- JP 2010212184 A
- WO 2009014707 A
- US 6608439 B

- JP 8112879 A
- JP 63017221 A
- JP 78199165218 B
- JP 11043327 A
- JP 2004068143 A